# EUROPEAN PATENT SPECIFICATION

(11) **EP 3 483 943 B1**
(45) Date of publication and mention of the grant of the patent: **28.04.2021**
(21) Application number: 17866375.3
(22) Date of filing: 29.09.2017
(51) Int. Cl.: H01L 33/48, H01L 33/62, H01L 33/50, H01L 33/52, H01L 33/10, H01L 33/20

(54) **LIGHT EMITTING DEVICE PACKAGE**
VERKAPSELUNG EINER LICHTEMITTIERENDEN VORRICHTUNG
BOÎTIER DE DISPOSITIF ÉLECTROLUMINESCENT

(30) Priority: 12.09.2017 KR 20170116308
(43) Date of publication of application: 15.05.2019
(73) Proprietor: LG Innotek Co., Ltd., Seoul 04637 (KR)
(72) Inventor: SONG, June O, Seoul 04637 (KR); KIM, Ki Seok, Seoul 04637 (KR); LIM, Chang Man, Seoul 04637 (KR)
(74) Representative: M. Zardi & Co S.A.
(86) International application number: PCT/KR2017/011090
(87) International publication number: WO 2019/054548

(56) References cited:
- JP-A- 2010 080 800
- KR-A- 20120 039 587
- KR-A- 20140 132 068
- KR-B1- 101 443 365
- US-A1- 2012 212 964
- US-A1- 2012 256 198
- US-A1- 2015 204 517
- US-A1- 2015 348 906
- US-A1- 2017 092 816

## Description

### [Technical Field]

The embodiment relates to a semiconductor device package, a method of manufacturing the semiconductor device package, and a light source apparatus.

### [Background Art]

A semiconductor device including compounds such as GaN and AlGaN has many merits such as wide and easily adjustable bandgap energy, so the device can be used variously as light emitting devices, light receiving devices and various kinds of diodes.

In particular, light emitting devices such as light emitting diodes and laser diodes obtained by using group III-V or group II-VI compound semiconductor substances can implement light having various wavelength band such as red, green, blue and ultraviolet rays due to the development of thin film growth technology and device materials. In addition, the light emitting devices such as light emitting diodes and laser diodes obtained by using group III-V or group II-VI compound semiconductor substances can implement a white light source having high efficiency by using fluorescent substances or combining colors. Such a light emitting device has advantages such as low power consumption, semi-permanent lifetime, quick response speed, safety, and environmental friendliness compared to conventional light sources such as fluorescent lamps and incandescent lamps.

In addition, when a light receiving device such as a photodetector or a solar cell is manufactured using the group III-V or group II-VI compound semiconductor substances, a photoelectric current is generated by absorbing light having various wavelength domains with the development of device materials, so that light having various wavelength domains such as from gamma rays to radio waves can be used. In addition, the above light receiving device has advantages such as quick response speed, safety, environmental friendliness and easy control of device materials, so that the light receiving device can be easily used for a power control, a super-high frequency circuit or a communication module.

Accordingly, the semiconductor device has been applied and expanded to a transmission module of an optical communication tool, a light emitting diode backlight replacing a cold cathode fluorescence lamp (CCFL) constituting a backlight of a liquid crystal display (LCD), a white light emitting diode lighting apparatus replaceable with a fluorescent lamp or an incandescent bulb, a vehicular headlight, a traffic light and a sensor for detecting gas or fire. In addition, the applications of the semiconductor device can be expanded to a high frequency application circuit, a power control apparatus, or a communication module.

For example, the light emitting device may be provided as a p-n junction diode having a characteristic in which electrical energy is converted into light energy by using a group III-V element or a group II-VI element in the periodic table, and various wavelengths can be realized by adjusting the composition ratio of the compound semiconductor substances.

For example, since a nitride semiconductor has high thermal stability and wide bandgap energy, it has received great attention in the field of development of optical devices and high power electronic devices. Particularly, a blue light emitting device, a green light emitting device, an ultraviolet (UV) light emitting device, and a red light emitting device using the nitride semiconductor are commercialized and widely used.

For example, the ultraviolet light emitting device refers to a light emitting diode that generates light distributed in a wavelength range of 200 nm to 400 nm. In the above wavelength range, a short wavelength may be used for sterilization, purification or the like and a long wavelength may be used for a stepper, a curing apparatus or the like.

Ultraviolet rays may be classified into UV-A (315 nm to 400 nm), UV-B (280 nm to 315 nm) and UV-C (200 nm to 280 nm) in an order of the long wavelength. The UV-A (315 nm to 400 nm) domain is applied to various fields such as industrial UV curing, curing of printing ink, exposure machine, discrimination of counterfeit money, photocatalytic sterilization, special lighting (such as aquarium/agriculture), the UV-B (280 nm to 315 nm) domain is applied to medical use, and the UV-C (200 nm to 280 nm) domain is applied to air purification, water purification, sterilization products and the like.

Meanwhile, as a semiconductor device capable of providing a high output has been requested, studied on a semiconductor device capable of increasing an output power by applying a high power source has been proceeding.

In addition, as for a semiconductor device package, studies on a method of improving the light extraction efficiency of a semiconductor device and improving the light intensity in a package stage has been proceeding. In addition, as for the semiconductor device package, studies on a method of improving bonding strength between a package electrode and a semiconductor device has been proceeding.

In addition, as for the semiconductor device package, studies on a method of reducing the manufacturing cost and improving the manufacturing yield by improving the process efficiency and changing the structure has been proceeding. US2015348906 A1 discloses an electronic device package including a package body, an electronic device, and at least one conductive via. KR20120039587 A1 discloses a wafer level light emitting diode package comprising an insulation reflecting layer and an electrode pattern formed on the upper side of a lower plate.

### [Disclosure]

### [Technical Problem]

The embodiments may provide a semiconductor device package capable of improving the light extraction efficiency and electrical characteristics, and a light source apparatus.

The embodiments may provide a semiconductor device package capable of reducing the manufacturing cost and improving the manufacturing yield, and a light source apparatus.

### [Technical Solution]

The invention is as defined in the appended claims. According to embodiments, a light emitting device package may include: a first package body including a flat lower surface, an upper surface parallel to the lower surface, and first and second opening parts provided through the upper surface and the lower surface; a second package body disposed on the first package body, and including an opening provided through an upper surface and a lower surface of the second package body; and a light emitting device disposed in the opening, and including a first bonding part and a second bonding part, wherein the upper surface of the first package body may be coupled with the lower surface of the second package body, the first bonding part may be disposed on the first opening part, and the second bonding part may be disposed on the second opening part.

According to embodiments, at least one of the first package body and the second package body may include a wavelength conversion material.

According to embodiments, at least one of the first package body and the second package body may be formed of a transparent resin.

According to embodiments, at least one of the first package body and the second package body may be formed of a reflective resin.

According to embodiments, the first package body and the second package body may include mutually different materials.

According to embodiments, the first package body and the second package body may include mutually different materials selected from PPA, PCT, EMC, SMC and PI, and the first package body may include a reflective material and the second package body may include a wavelength conversion material.

According to embodiments, the first package body and the second package body may include mutually different materials selected from PPA, PCT, EMC, SMC and PI, and the first package body may include a wavelength conversion material and the second package body may include a reflective material.

According to embodiments, the first package body and the second package body may include mutually different materials selected from PPA, PCT, EMC, SMC and PI, and the first package body may include a transparent resin and the second package body may include at least one of a wavelength conversion material and a reflective material.

According to embodiments, the light emitting device package may include an adhesive layer disposed between the first package body and the second package body.

According to embodiments, the first package body may include a recess concavely provided in a direction from the upper surface to the lower surface of the first package body, the recess may be arranged between the first opening part and the second opening part, and a first resin may be disposed in the recess while making contact with a lower surface of the light emitting device.

### [Advantageous Effects]

The semiconductor device package according to the embodiment can improve light extraction efficiency, electrical characteristics and reliability.

The semiconductor device package according to the embodiment can improve the process efficiency and propose a new package structure, thereby reducing manufacturing cost and improving manufacturing yield.

According to embodiments, the semiconductor device package is provided with a body having high reflectance, so that a reflector can be prevented from being discolored, thereby improving reliability of the semiconductor device package.

### [Description of Drawings]

FIG. 1 is a view showing a light emitting device package according to an embodiment.
FIG. 2 is an exploded perspective view for describing the light emitting device package according to an embodiment of the present invention.
FIG. 3 is a view for describing the arrangement of a package body, a recess, and an opening part of the light emitting device package according to an embodiment of the present invention.
FIGS. 4 to 8 are views for describing a method of manufacturing a light emitting device package according to an embodiment.
FIG. 9 is a view showing a light emitting device package according to another embodiment.
FIG. 10 is a view showing a light emitting device package according to still another embodiment.
FIG. 11 is a view showing a light emitting device package according to the present invention.
FIG. 12 is a plan view for describing a light emitting device applied to the light emitting device package according to an embodiment of the present invention.
FIG. 13 is a sectional view showing the light emitting device taken along line A-A of FIG. 12.
FIG. 14 is a plan view for describing a light emitting device applied to the light emitting device package according to another embodiment of the present invention.
FIG. 15 is a sectional view showing the light emitting device taken along line F-F of FIG. 14.

### [Mode for Invention]

Hereinafter, embodiments will be described with reference to the accompanying drawings. In the description of the embodiments, in the case that each layer (film), region, pattern or structure may be referred to as provided "on/over" or "under" a substrate, each layer (film), region, pad, or pattern, the terms "on/over" and "under" include both "directly" and "indirectly interposed with another layer". In addition, "on/over" or "under" of each layer will be described based on the drawings, but the embodiments are not limited thereto.

Hereinafter, a semiconductor device package and a method of manufacturing the semiconductor device package according to the embodiment will be described in detail with reference to the accompanying drawings. Hereinafter, the description will be based on a case where a light emitting device is applied as an example of the semiconductor device.

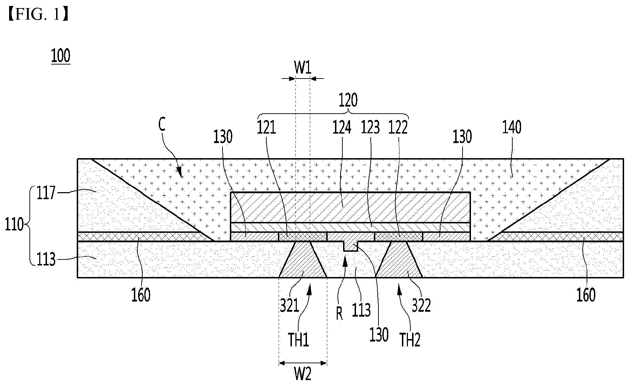

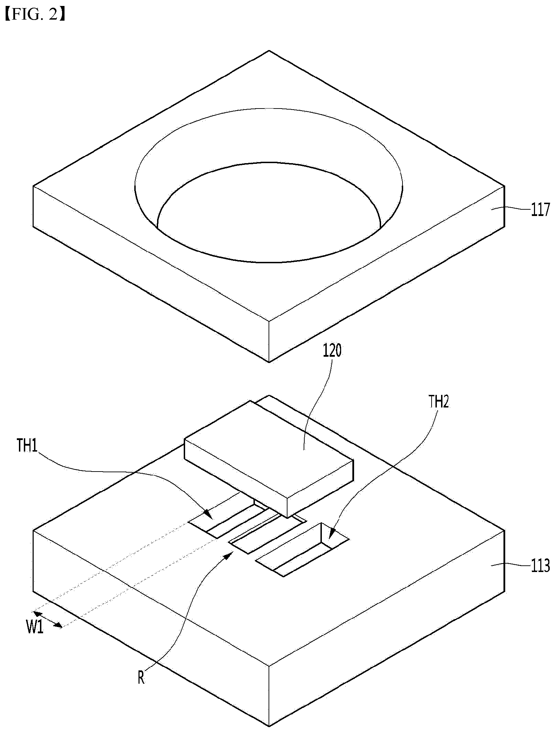

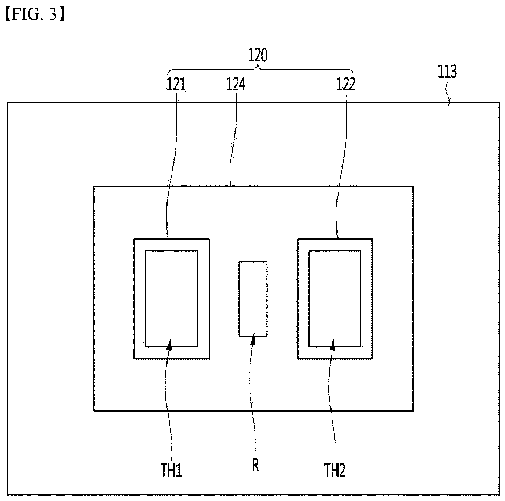

First, a light emitting device package according to an embodiment. will be described with reference to FIGS. 1 to 3. FIG. 1 is a view showing a light emitting device package according to an embodiment of the present invention, FIG. 2 is an exploded perspective view for describing the light emitting device package according to an embodiment of the present invention, and FIG. 3 is a view for describing the arrangement of a package body, a recess, and an opening part of the light emitting device package according to an embodiment of the present invention.

According to an embodiment, as shown in FIGS. 1 to 3, a light emitting device package 100 may include a package body 110 and a light emitting device 120.

The package body 110 may include a first package body 113 and a second package body 117. The second package body 117 may be disposed on the first package body 113. The second package body 117 may be disposed at a periphery of an upper surface of the first package body 113. The second package body 117 may form a cavity C over the upper surface of the first package body 113. The second package body 117 may include an opening provided through an upper surface and a lower surface of the second package body 117.

In other words, the first package body 113 may be referred to as a lower body, and the second package body 117 may be referred to as an upper body. In addition, according to an embodiment, the package body 110 may not include the second package body 117 that forms the cavity, but may include only the first package body 113 having a flat upper surface.

The second package body 117 may reflect light emitted from the light emitting device 120 in an upward direction. The second package body 117 may be inclined with respect to the upper surface of the first package body 113.

The package body 110 may include the cavity C. The cavity may include a bottom surface, and a side surface inclined to an upper surface of the package body 110 from the bottom surface.

According to an embodiment, the package body 110 may have a structure provided with the cavity C, or may have a structure provided with a flat upper surface without the cavity C.

For example, the package body 110 may be formed of one selected from the group consisting of Polyphthalamide (PPA), Polychloro Tri phenyl (PCT), liquid crystal polymer (LCP), Polyamide9T (PA9T), silicone, an epoxy molding compound (EMC), a silicone molding compound (SMC), ceramic, Poly Imide (PI), photo sensitive glass (PSG), a sapphire (Al₂O₃), and the like. In addition, the package body 110 may include a reflective material including a high refractive filler such as TiO₂ or SiO₂. The package body 110 may include a wavelength conversion material such as a quantum dot or a fluorescent substance.

Meanwhile, according to an embodiment, the first package body 113 and the second package body 117 may include mutually different materials. For example, the first package body 113 and the second package body 117 may be formed of mutually different materials in mutually different processes, and then coupled to each other. For example, the first package body 113 and the second package body 117 may be coupled to each other through an adhesive layer 160.

The adhesive layer 160 is disposed between the first package body 113 and the second package body 117. The adhesive layer 160 may be disposed on the upper surface of the first package body 113. The adhesive layer 160 may be disposed on the lower surface of the second package body 117. The adhesive layer 160 is disposed at a periphery of the light emitting device 120 to form the cavity.

The adhesive layer 160 may include at least one of an epoxy-based material, a silicone-based material, a hybrid material including the epoxy-based material and the silicone-based material. In addition, the adhesive layer 160 may reflect the light emitted from the light emitting device 120. If the adhesive layer 160 includes a reflection function, the adhesive may include white silicone.

Meanwhile, each of the first package body 113 and the second package body 117 may include at least one selected from resin materials including Polyphthalamide (PPA), Polychloro Tri phenyl (PCT), liquid crystal polymer (LCP), Polyamide9T (PA9T), silicone, an epoxy molding compound (EMC), a silicone molding compound (SMC), Poly Imide (PI), and the like as a base material.

In addition, each of the first package body 113 and the second package body 117 may include at least one of a reflective material and a wavelength conversion material. In addition, the first package body 113 and the second package body 117 may not include a reflective material and a wavelength conversion material. The first package body 113 and the second package body 117 may be formed of a transparent resin.

The first package body 113 and the second package body 117 may include mutually different base materials.

For example, the first package body 113 may include a reflective material, and the second package body 117 may include a wavelength conversion material. In addition, the first package body 113 may include a wavelength conversion material, and the second package body 117 may include a reflective material.

According to an embodiment, the first package body 113 may include a reflective material, and the second package body 117 may include a reflective material and a wavelength conversion material. In addition, the first package body 113 may include a reflective material and a wavelength conversion material, and the second package body 117 may include a wavelength conversion material.

According to the light emitting device package 100 of an embodiment, the first package body 113 and the second package body 117 including mutually different base materials may be separately formed in mutually different processes, and manufactured in a modular scheme by selectively combining components to satisfy the characteristics required for applications. A method of manufacturing a light emitting device package according to an embodiment will be discussed later in further detail.

According to an embodiment, the light emitting device 120 may include a first bonding part 121, a second bonding part 122, a light emitting structure 123, and a substrate 124.

The light emitting device 120 may include the light emitting structure 123 disposed under the substrate 124. The light emitting structure 123 may include a first conductive semiconductor layer, a second conductive semiconductor layer, and an active layer disposed between the first conductive semiconductor layer and the second conductive semiconductor layer. The first bonding part 121 may be electrically connected to the first conductive semiconductor layer. The second bonding part 122 may be electrically connected to the second conductive semiconductor layer.

The light emitting device 120 may be disposed on the package body 110. The light emitting device 120 may be disposed on the first package body 113. The light emitting device 120 may be disposed in the cavity C provided by the second package body 117.

The first bonding part 121 may be disposed on the lower surface of the light emitting device 120. The second bonding part 122 may be disposed on the lower surface of the light emitting device 120. The first bonding part 121 and the second bonding part 122 may be spaced apart from each other on the lower surface of the light emitting device 120.

The first bonding part 121 may be disposed between the light emitting structure 123 and the first package body 113. The second bonding part 122 may be disposed between the light emitting structure 123 and the first package body 113.

The first bonding part 121 and the second bonding part 122 may be prepared as a single layer or a multi-layer formed of at least one material selected from the group consisting of Ti, Al, Sn, In, Ir, Ta, Pd, Co, Cr, Mg, Zn, Ni, Si, Ge, Ag, an Ag alloy, Au, Hf, Pt, Ru, Rh, ZnO, IrOx, RuOx, NiO, RuOx/ITO, Ni/IrOx/Au, and Ni/IrOx/Au/ITO, or an alloy thereof.

Meanwhile, according to an embodiment, as shown in FIGS. 1 to 3, the light emitting device package 100 includes a first opening part TH1 and a second opening part TH2.

The package body 110 includes the first opening part TH1 provided through the lower surface of the package body 110 in a bottom surface of the cavity C. The package body 110 includes the second opening part TH2 provided through the lower surface of the package body 110 in the bottom surface of the cavity C.

For example, the first package body 113 may include a flat lower surface, and an upper surface parallel to the lower surface. The first and second opening parts TH1 and TH2 may be provided through the upper surface and the lower surface of the first package body 113.

The first opening part TH1 may be provided in the first package body 113. The first opening part TH1 may be provided through the first package body 113. The first opening part TH1 may be provided through the upper surface and the lower surface of the first package body 113 in a first direction.

The first opening part TH1 may be arranged under the first bonding part 121 of the light emitting device 120. The first opening part TH1 may overlap with the first bonding part 121 of the light emitting device 120. The first opening part TH1 may overlap with the first bonding part 121 of the light emitting device 120 in the first direction, which is directed from the upper surface toward the lower surface of the first package body 113.

The second opening part TH2 may be provided in the first package body 113. The second opening part TH2 may be provided through the first package body 113. The second opening part TH2 may be provided through the upper surface and the lower surface of the first package body 113 in the first direction.

The second opening part TH2 may be arranged under the second bonding part 122 of the light emitting device 120. The second opening part TH2 may overlap with the second bonding part 122 of the light emitting device 120. The second opening part TH2 may overlap with the second bonding part 122 of the light emitting device 120 in the first direction, which is directed from the upper surface toward the lower surface of the first package body 113.

The first opening part TH1 and the second opening part TH2 may be spaced apart from each other. The first opening part TH1 and the second opening part TH2 may be spaced apart from each other under the lower surface of the light emitting device 120.

According to an embodiment, a width W1 of an upper region of the first opening part TH1 may be equal to or smaller than a width of the first bonding part 121. In addition, a width of an upper region of the second opening part TH2 may be equal to or smaller than a width of the second bonding part 122.

In addition, the width W1 of the upper region of the first opening part TH1 may be equal to or smaller than a width W2 of a lower region of the first opening part TH1. In addition, the width of the upper region of the second opening part TH2 may be equal to or smaller than a width of a lower region of the second opening part TH2.

The first opening part TH1 may be inclined such that the width of the first opening part TH1 gradually decreases from the lower region toward the upper region of the first opening part TH1. The second opening part TH2 may be inclined such that the width of the second opening part TH2 gradually decreases from the lower region toward the upper region of the second opening part TH2.

However, embodiments are not limited thereto, and a plurality of inclined surfaces having mutually different slopes may be provided between the upper region and the lower region of the first and second opening parts TH1 and TH2, in which the inclined surfaces may have a curvature. A width between the first opening part TH1 and the second opening part TH2 in a lower surface region of the first package body 113 may be several hundreds of micrometers. The width between the first opening part TH1 and the second opening part TH2 in the lower surface region of the first package body 113 may be 100 micrometers to 150 micrometers.

According to an embodiment, when the light emitting device package 100 is later mounted on a circuit board, a sub-mount or the like, the width between the first opening part TH1 and the second opening part TH2 in the lower surface region of the first package body 113 may be set to be a predetermined distance or more in order to prevent an electrical short from occurring between the bonding parts.

According to an embodiment, as shown in FIGS. 1 to 3, the light emitting device package 100 may include a recess R. The recess R may be concavely provided at the bottom surface of the cavity C toward the lower surface of the package body 110.

The recess R may be provided in the first package body 113. The recess R may be concavely provided in a direction from the upper surface to the lower surface of the first package body 113. The recess R may be arranged under the light emitting device 120.

The recess R may be arranged under the light emitting device 120 while being arranged between the first bonding part 121 and the second bonding part 122. The recess R may extend under the light emitting device 120 in a short axis direction of the light emitting device 120.

According to an embodiment, as shown in FIG. 1, the light emitting device package 100 may include a first resin 130.

The first resin 130 may be disposed in the recess R. The first resin 130 may be disposed between the light emitting device 120 and the first package body 113. The first resin 130 may be disposed between the first bonding part 121 and the second bonding part 122. For example, the first resin 130 may make contact with a side surface of the first bonding part 121 and a side surface of the second bonding part 122.

The first resin 130 may be disposed at a periphery of the first bonding part 121 to seal the upper region of the first opening part TH1. The first resin 130 may be disposed at a periphery of the second bonding part 122 to seal the upper region of the second opening part TH1.

The first resin 130 may provide stable fixing strength between the light emitting device 120 and the first package body 113. For example, the first resin 130 may make direct contact with the upper surface of the first package body 113. In addition, the first resin 130 may make direct contact with the lower surface of the light emitting device 120.

For example, the first resin 130 may include at least one of an epoxy-based material, a silicone-based material, a hybrid material including the epoxy-based material and the silicone-based material. In addition, the first resin 130 may reflect light emitted from the light emitting device 120. If the first resin 130 includes a reflection function, an adhesive may include white silicone. If the first resin 130 includes a reflection function, the first resin 130 may be, for example, formed of a material including TiO₂, SiO₂ or the like. The first resin 130 may be referred to as the adhesive.

According to an embodiment, a depth of the recess R may be smaller than a depth of the first opening part TH1 or a depth of the second opening part TH2.

The depth of the recess R may be determined in consideration of adhesive strength of the first resin 130. In addition, the depth T1 of the recess R may be determined in consideration of stable strength of the first package body 113 and/or determined to prevent a crack from being generated on the light emitting device package 100 due to heat emitted from the light emitting device 120.

The recess R may provide a space suitable for performing a sort of an under fill process at a lower portion of the light emitting device 120. The recess R may have a first depth or more to sufficiently provide the first resin 130 between the lower surface of the light emitting device 120 and the upper surface of the first package body 113. In addition, the recess R may have a second depth or less to provide stable strength to the first package body 113.

The depth and a width of the recess R may influence a position and fixing strength of the first resin 130. The depth and width of the recess R may be determined such that sufficient fixing strength is provided by the first resin 130 disposed between the first package body 113 and the light emitting device 120.

For example, the depth of the recess R may be several tens of micrometers. The depth of the recess R may be 40 micrometers to 60 micrometers.

In addition, the width of the recess R may be several hundreds of micrometers. The width of the recess R may be 140 micrometers to 160 micrometers. For example, the width W3 of the recess may be 150 micrometers.

The depth of the first opening part TH1 may be determined corresponding to a thickness of the first package body 113. The depth of the first opening part TH1 may be determined such that the first package body 113 may maintain stable strength.

For example, the depth of the first opening part TH1 may be several hundreds of micrometers. The depth of the first opening part TH1 may be 180 micrometers to 220 micrometers. For example, the depth of the first opening part TH1 may be 200 micrometers.

For example, a thickness defined by subtracting the depth of the recess R from the depth of the first opening part TH1 may be set to be 100 micrometers or more. The above thickness is selected by taking into consideration a thickness for an injection molding process, which may allow the crack free of the first package body 113.

According to an embodiment, the depth of the first opening part TH1 may be 2 to 10 times based on the depth of the recess R. For example, if the depth of the first opening part TH1 is 200 micrometers, the depth of the recess R may be 20 micrometers to 100 micrometers.

In addition, according to an embodiment, as shown in FIG. 1, the light emitting device package 100 may include a second resin 140.

The second resin 140 may be provided on the light emitting device 120. The second resin 140 may be disposed on the first package body 113. The second resin 140 may be disposed in the cavity C provided by the second package body 117.

The second resin 140 may include an insulating material. In addition, the second resin 140 may include a wavelength conversion material for receiving light emitted from the light emitting device 120 to provide wavelength-converted light. For example, the second resin 140 may include a fluorescent substance, a quantum dot or the like.

In addition, according to an embodiment, the light emitting structure 123 may be a compound semiconductor. For example, the light emitting structure 123 may be a Group II-VI or Group III-V compound semiconductor. For example, the light emitting structure 123 may include at least two elements selected from aluminum (Al), gallium (Ga), indium (In), phosphorus (P), arsenic (As), and nitrogen (N).

The light emitting structure 123 may include a first conductive semiconductor layer, an active layer, and a second conductive semiconductor layer.

The first and second conductive semiconductor layers may be implemented as at least one among Group III-V or Group II-VI compound semiconductors. The first and second conductive semiconductor layers may be, for example, formed of a semiconductor material having a composition formula of InₓAl_{y}Ga_{1-x-y}N, wherein 0≤x≤1, 0≤y≤1, and 0≤x+y≤1. For example, the first and second conductive semiconductor layers may include at least one selected from the group consisting of GaN, A1N, AlGaN, InGaN, InN, InAlGaN, AlInN, AlGaAs, GaP, GaAs, GaAsP, AlGaInP, and the like. The first conductive semiconductor layer may be an n-type semiconductor layer doped with an n-type dopant such as Si, Ge, Sn, Se, or Te. The second conductive semiconductor layer may be a p-type semiconductor layer doped with a p-type dopant such as Mg, Zn, Ca, Sr, or Ba.

The active layer may be implemented as a compound semiconductor. The active layer may be implemented as, for example, at least one among Group III-V or Group II-VI compound semiconductors. If the active layer is implemented as a multiwell structure, the active layer may include a plurality of well layers and a plurality of barrier layers, which are alternately arranged with each other, and may be formed of a semiconductor material having a composition formula of InₓAl_{y}Ga_{1-x-y}N, wherein 0≤x≤1, 0≤y≤1, and 0≤x+y≤1. For example, the active layer may include at least one selected from the group consisting of InGaN/GaN, GaN/AlGaN, AlGaN/AlGaN, InGaN/AlGaN, InGaN/InGaN, AlGaAs/GaAs, InGaAs/GaAs, InGaP/GaP, AlInGaP/InGaP, and InP/GaAs.

In addition, according to an embodiment, as shown in FIG. 1, the light emitting device package 100 may include a first conductive layer 321 and a second conductive layer 322. The first conductive layer 321 may be spaced apart from the second conductive layer 322.

The first conductive layer 321 may be provided in the first opening part TH1. The first conductive layer 321 may be disposed under the first bonding part 121. A width of the first conductive layer 321 may be smaller than the width of the first bonding part 121.

The first bonding part 121 may have the width in a second direction perpendicular to the first direction along which the first opening part TH1 is provided. The width of the first bonding part 121 may be larger than the width of the first opening part TH1 in the second direction.

The first conductive layer 321 may make direct contact with a lower surface of the first bonding part 121. The first conductive layer 321 may be electrically connected to the first bonding part 121. The first conductive layer 321 may be surrounded by the first package body 113.

The second conductive layer 322 may be provided in the second opening part TH2. The second conductive layer 322 may be disposed under the second bonding part 122. A width of the second conductive layer 322 may be smaller than the width of the second bonding part 122.

The second bonding part 122 may have the width in the second direction perpendicular to the first direction along which the second opening part TH2 is provided. The width of the second bonding part 122 may be larger than the width of the second opening part TH2 in the second direction.

The second conductive layer 322 may make direct contact with a lower surface of the second bonding part 122. The second conductive layer 322 may be electrically connected to the second bonding part 122. The second conductive layer 322 may be surrounded by the first package body 113.

The first conductive layer 321 and the second conductive layer 322 may include at least one material selected from the group consisting of Ag, Au, Pt, Sn, Cu, and the like, or an alloy thereof. However, embodiments are not limited thereto, and the first conductive layer 321 and the second conductive layer 322 may be formed of a material capable of ensuring a conductive function.

For example, the first conductive layer 321 and the second conductive layer 322 may be formed of a conductive paste. The conductive paste may include a solder paste, a silver paste or the like, and may be prepared as a multi-layer formed of mutually different materials, or a multi-layer or a single layer formed of an alloy. For example, the first conductive layer 321 and the second conductive layer 322 may include a SnAg-Cu (SAC) material.

According to an embodiment, the first conductive layer 321 may be electrically connected to the first bonding part 121, and the second conductive layer 322 may be electrically connected to the second bonding part 122. For example, external power may be supplied to the first conductive layer 321 and the second conductive layer 322, thereby driving the light emitting device 120.

The first resin 130 may perform a function of stably fixing the light emitting device 120 to the package body 110. In addition, the first resin 130 may be disposed at a periphery of the first and second bonding parts 121 and 122 while making contact with the side surfaces of the first and second bonding parts 121 and 122. When viewed from the top of the light emitting device 120, the first resin 130 is disposed such that the first and second opening parts TH1 and TH2 are isolated from an outer region where the second resin 140 is provided.

Due to the first resin 130, the first and second conductive layers 321 and 322 respectively provided in the first and second opening parts TH1 and TH2 may be prevented from flowing outward of the light emitting device 120.

When viewed from the top of the light emitting device 120, if the first and second conductive layers 321 and 322 move outward of the light emitting device 120, the first and second conductive layers 321 and 322 may be diffused along a side surface of the light emitting device 120. If the first and second conductive layers 321 and 322 move to the side surface of the light emitting device 120 as described above, the first conductive semiconductor layer and the second conductive semiconductor layer of the light emitting device 120 may be electrically short-circuited. In addition, if the first and second conductive layers 321 and 322 move to the side surface of the light emitting device 120, light extraction efficiency of the light emitting device 120 may be reduced.

However, according to an embodiment, since peripheral regions of the first and second bonding parts 121 and 122 can be sealed by the first resin 130, the first and second conductive layers 321 and 322 may be prevented from overflowing outward of regions of the first and second opening parts TH1 and TH2.

Therefore, according to the light emitting device package 100 of an embodiment, the first and second conductive layers 321 and 322 can be prevented from moving to the side surface of the light emitting device 120, the light emitting device 120 can be prevented from being electrically short-circuited, and the light extraction efficiency can be improved.

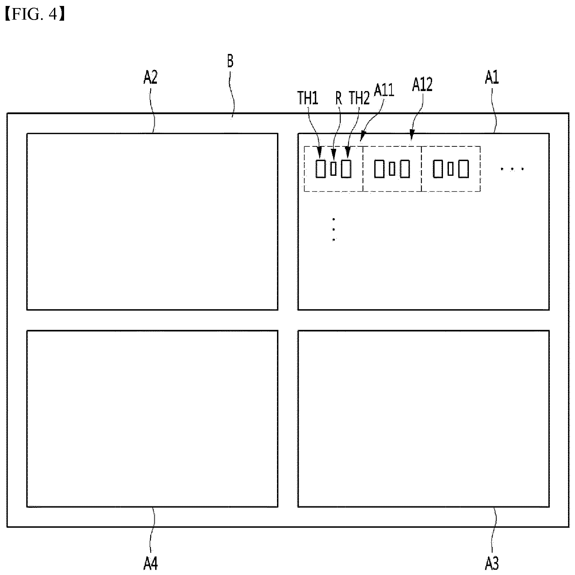

Hereinafter, a method of manufacturing a light emitting device package according to an embodiment of the present invention will be described with reference to FIGS. 4 to 8.

Upon describing the method of manufacturing the light emitting device package according to an embodiment of the present invention with reference to FIGS. 4 to 8, the descriptions that overlap with those described with reference to FIGS. 1 to 3 may be omitted.

First, according to the method of manufacturing the light emitting device package of an embodiment of the present invention, as shown in FIG. 4, a support frame B and a plurality of first body arrays A1, A2, A3, and A4 disposed in the support frame B may be provided.

The support frame B may stably support the first body arrays A1, A2, A3, and A4. The support frame B may be an insulating frame or a conductive frame.

For example, the first body arrays A1, A2, A3, and A4 may be provided through an injection molding process or the like.

FIG. 4 shows a case where four first body arrays A1, A2, A3, and A4 are disposed on the support frame B. However, three or less first body arrays may be provided, or five or more first body arrays may be provided. In addition, the first body arrays may be arranged in a plurality of rows and a plurality of columns, or may be arranged in one row and a plurality of columns.

Each of the first body arrays A1, A2, A3, and A4 may include a plurality of sub-body arrays A11, A12, ....

Each of the sub-body arrays A11, A12, ... may include the first package body 113, the first and second opening parts TH1 and TH2, and the recess R as described with reference to FIGS. 1 to 3. In addition, each of the sub-body arrays A11, A12, ... may be provided in a structure similar to each other. The first opening part TH1 may be provided in the first package body 113. The first opening part TH1 may be provided through the first package body 113. The first opening part TH1 may be provided through the upper surface and the lower surface of the first package body 113 in the first direction.

The second opening part TH2 may be provided in the first package body 113. The second opening part TH2 may be provided through the first package body 113. The second opening part TH2 may be provided through the upper surface and the lower surface of the first package body 113 in the first direction.

The first opening part TH1 and the second opening part TH2 may be spaced apart from each other.

The recess R may be provided in the first package body 113. The recess R may be concavely provided in a direction from the upper surface to the lower surface of the first package body 113.

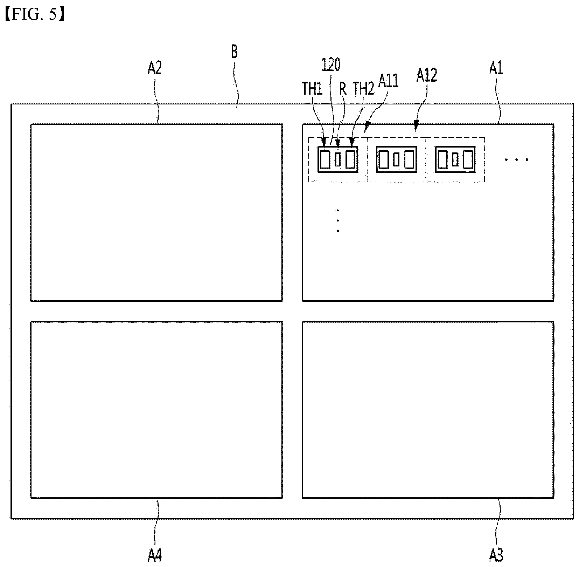

Next, according to the method of manufacturing the light emitting device package of an embodiment, as shown in FIG. 5, the light emitting device 120 may be disposed on each of the sub-body arrays A11, A12, ....

As described with reference to FIGS. 1 to 3, the first resin 130 may be provided in the recess R, and the light emitting device 120 may be mounted.

The first resin 130 may be provided in a region of the recess R through a doting scheme or the like. For example, the first resin 130 may be provided in the region where the recess R is provided by a predetermined amount, and may be provided to the extent that the first resin 130 overflows from the recess R.

In addition, the light emitting device 120 may be provided on the first package body 113.

According to an embodiment, the recess R may serve as a sort of an align key in a process of disposing the light emitting device 120 on the package body 110.

The light emitting device 120 may be fixed to the first package body 113 by the first resin 130. A part of the first resin 130 provided in the recess R may be moved toward the first bonding part 121 and the second bonding part 122 of the light emitting device 120 and cured. Accordingly, the first resin 130 may be provided in a wide region between the lower surface of the light emitting device 120 and the upper surface of the first package body 113, thereby improving the fixing strength between the light emitting device 120 and the first package body 113.

According to an embodiment, the first opening part TH1 may be arranged under the first bonding part 121 of the light emitting device 120. The first opening part TH1 may overlap with the first bonding part 121 of the light emitting device 120. The first opening part TH1 may overlap with the first bonding part 121 of the light emitting device 120 in the first direction, which is directed from the upper surface toward the lower surface of the first package body 113.

The second opening part TH2 may be arranged under the second bonding part 122 of the light emitting device 120. The second opening part TH2 may overlap with the second bonding part 122 of the light emitting device 120. The second opening part TH2 may overlap with the second bonding part 122 of the light emitting device 120 in the first direction, which is directed from the upper surface toward the lower surface of the first package body 113.

The first resin 130 may function to stably fix the light emitting device 120 to the package body 110. In addition, the first resin 130 may be disposed at peripheries of the first and second bonding parts 121 and 122 while making contact with the side surfaces of the first and second bonding parts 121 and 122.

Next, according to the method of manufacturing the light emitting device package of an embodiment, as described with reference to FIGS. 1 to 3, the first and second opening parts TH1 and TH2 of each of the sub-body arrays A11, A12, ... may be provided with the first and second conductive layers 321 and 322, respectively.

The first conductive layer 321 may be provided in the first opening part TH1. The first conductive layer 321 may be disposed under the first bonding part 121. The width of the first conductive layer 321 may be smaller than the width of the first bonding part 121.

The first bonding part 121 may have the width in the second direction perpendicular to the first direction along which the first opening part TH1 is provided. The width of the first bonding part 121 may be larger than the width of the first opening part TH1 in the second direction.

The first conductive layer 321 may make direct contact with the lower surface of the first bonding part 121. The first conductive layer 321 may be electrically connected to the first bonding part 121. The first conductive layer 321 may be surrounded by the first package body 113.

The second conductive layer 322 may be provided in the second opening part TH2. The second conductive layer 322 may be disposed under the second bonding part 122. The width of the second conductive layer 322 may be smaller than the width of the second bonding part 122.

The second bonding part 122 may have the width in the second direction perpendicular to the first direction along which the second opening part TH2 is provided. The width of the second bonding part 122 may be larger than the width of the second opening part TH2 in the second direction.

The second conductive layer 322 may make direct contact with the lower surface of the second bonding part 122. The second conductive layer 322 may be electrically connected to the second bonding part 122. The second conductive layer 322 may be surrounded by the first package body 113.

The first conductive layer 321 and the second conductive layer 322 may include one material selected from the group consisting of Ag, Au, Pt, Sn, Cu, and the like, or an alloy thereof. However, embodiments are not limited thereto, and the first conductive layer 321 and the second conductive layer 322 may be formed of a material capable of ensuring a conductive function.

For example, the first conductive layer 321 and the second conductive layer 322 may be formed of a conductive paste. The conductive paste may include a solder paste, a silver paste or the like, and may be prepared as a multi-layer formed of mutually different materials, or a multi-layer or a single layer formed of an alloy. For example, the first conductive layer 321 and the second conductive layer 322 may include a SnAg-Cu (SAC) material.

Since the upper regions of the first and second opening parts TH1 and TH2 can be sealed by the first resin 130, the first and second conductive layers 321 and 322 respectively provided in the first and second opening parts TH1 and TH2 may be prevented from being diffused under the lower surface of the light emitting device 120.

Since the first and second opening parts TH1 and TH2 can be sealed by the first resin 130 as described above, the first and second conductive layers 321 and 322 respectively provided in the first and second opening parts TH1 and TH2 may be prevented from moving onto the upper surface of the first package body 113.

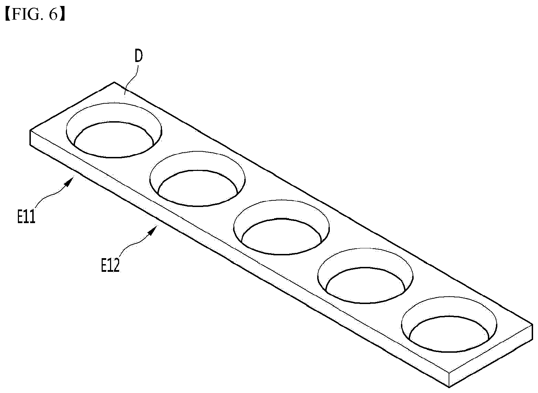

Meanwhile, according to the method of manufacturing the light emitting device package of an embodiment, as shown in FIG. 6, a second body array D may be provided.

The second body array D may include a plurality of sub-body arrays E11, E12, .... For example, the second body array D may include a plurality of sub-body arrays E11, E12, ... arranged in one direction as shown in FIG. 6. In addition, the second body array D may include a plurality of sub-body arrays E11, E12, ... arranged in the form of a matrix having a plurality of columns and a plurality of rows.

As shown in FIG. 6, each of the sub-body arrays E11, E12, ... may include an opening part provided in a direction from an upper surface to a lower surface of each of the sub-body arrays E11, E12, ....

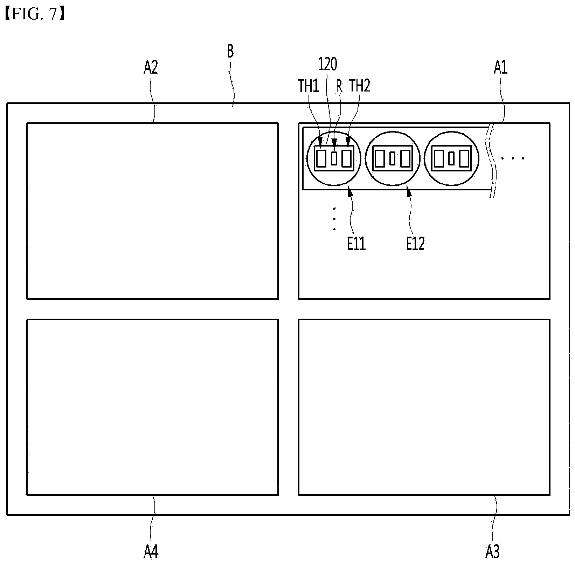

Next, according to the method of manufacturing the light emitting device package of an embodiment, as shown in FIG. 7, the second body array D may be provided on the first body arrays A1, A2, A3, and A4.

As described with reference to FIGS. 1 to 3, the first body arrays A1, A2, A3, and A4 and the second body array D may be coupled to each other through the adhesive layer 160.

For example, the sub-body array E11 may be disposed on the sub-body array A11, and the sub-body array E12 may be disposed on the sub-body array A12.

Meanwhile, according to an embodiment, the first body arrays A1, A2, A3, and A4 and the second body array D may include mutually different materials. For example, the first body arrays A1, A2, A3, and A4 and the second body array D may be formed of mutually different materials in mutually different processes, and then coupled to each other through the adhesive layer 160.

The adhesive layer 160 may be disposed between the first body arrays A1, A2, A3, and A4 and the second body array D. The adhesive layer 160 may be disposed on upper surfaces of the first body arrays A1, A2, A3, and A4. The adhesive layer 160 may be disposed on a lower surface of the second body array D.

The adhesive layer 160 may include at least one of an epoxy-based material, a silicone-based material, a hybrid material including the epoxy-based material and the silicone-based material. In addition, the adhesive layer 160 may reflect the light emitted from the light emitting device 120. If the adhesive layer 160 includes a reflection function, the adhesive may include white silicone.

Meanwhile, each of the first body arrays A1, A2, A3, and A4 and the second body array D may include at least one selected from resin materials including Polyphthalamide (PPA), Polychloro Tri phenyl (PCT), liquid crystal polymer (LCP), Polyamide9T (PA9T), silicone, an epoxy molding compound (EMC), a silicone molding compound (SMC), Poly Imide (PI), and the like as a base material.

In addition, each of the first body arrays A1, A2, A3, and A4 and the second body array D may include at least one of a reflective material and a wavelength conversion material. In addition, the first body arrays A1, A2, A3, and A4 and the second body array D may not include a reflective material and a wavelength conversion material.

The first body arrays A1, A2, A3, and A4 and the second body array D may include mutually different base materials.

For example, the first body arrays A1, A2, A3, and A4 may include a reflective material, and the second body array D may include a wavelength conversion material. In addition, first body arrays A1, A2, A3, and A4 may include a wavelength conversion material, and the second body array D may include a reflective material.

According to an embodiment, the first body arrays A1, A2, A3, and A4 may include a reflective material, and the second body array D may include a reflective material and a wavelength conversion material. In addition, the first body arrays A1, A2, A3, and A4 may include a reflective material and a wavelength conversion material, and the second body array D may include a wavelength conversion material.

According to the light emitting device package of an embodiment, the first body arrays A1, A2, A3, and A4 and the second body array D including mutually different base materials may be separately provided in mutually different processes, and manufactured in a modular scheme by selectively combining components to satisfy the characteristics required for applications.

Next, as described with reference to FIGS. 1 to 3, the cavity provided by the opening part of the second body array D may be provided with a second resin 140.

The second resin 140 may be provided on the light emitting device 120. The second resin 140 may be disposed on the first body arrays A1, A2, A3, and A4. The second resin 140 may be disposed in the cavity C provided by the second body array D.

The second resin 140 may include an insulating material. In addition, the second resin 140 may include a wavelength conversion material for receiving light emitted from the light emitting device 120 to provide wavelength-converted light. For example, the second resin 140 may include a fluorescent substance, a quantum dot or the like.

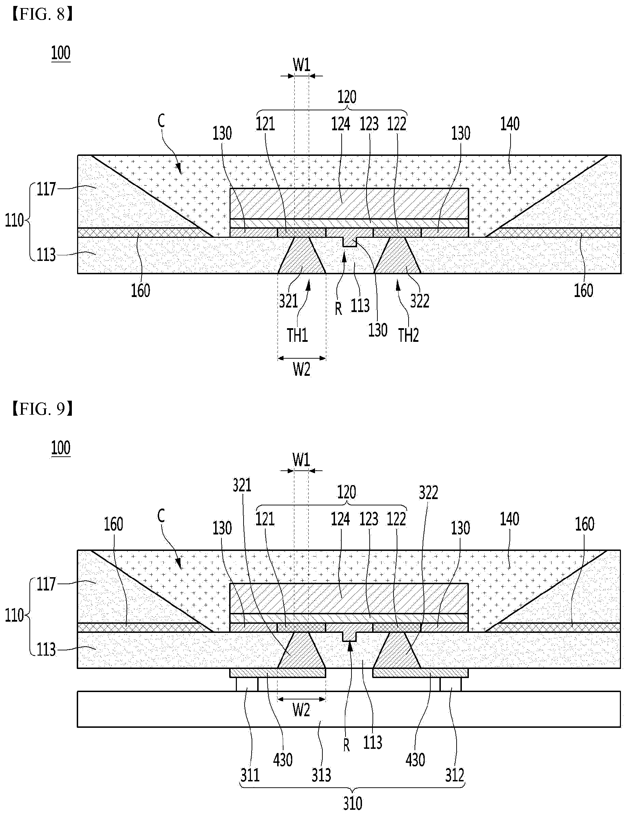

Next, according to the method of manufacturing the light emitting device package of an embodiment, in a state in which the first body arrays A1, A2, A3, and A4 and the second body array D are coupled to each other, an individual light emitting device package as shown in FIG. 8 may be manufactured through a separation process such as dicing or scribing.

According to an embodiment, as shown in FIG. 8, the light emitting device package 100 may include the package body 110 in which the first package body 113 and the second package body 117 are manufactured and coupled to each other through a modular scheme.

According to the light emitting device package 100 of an embodiment, as described with reference to FIGS. 1 to 7, a conventional lead frame is not applied when the package body 110 is provided.

In the case of the light emitting device package to which the conventional lead frame is applied, an additional process of forming the lead frame is required. However, according to an embodiment of the present invention, the non-claimed method of manufacturing the light emitting device package does not require the process of forming the lead frame. Accordingly, according to the method of manufacturing the light emitting device package of an embodiment of the present invention, a process time can be shortened and a material can be reduced.

In addition, in the case of the light emitting device package to which the conventional lead frame is applied, it is necessary to add a plating process using silver or the like to prevent deterioration of the lead frame. However, according to the method of manufacturing the light emitting device package of an embodiment of the present invention, the lead frame is not required, so that an additional process such as a silver plating process is unnecessary. Accordingly, according to the method of manufacturing the light emitting device package of an embodiment of the present invention, a manufacturing cost may be reduced and a manufacturing yield may be improved.

In addition, the light emitting device package according to an embodiment of the present invention can be miniaturized as compared with the light emitting device package to which the conventional lead frame is applied.

According to the light emitting device package 100 of an embodiment, a power source may be connected to the first bonding part 121 through the first conductive layer 321 provided in the first opening part TH1, and the power source may be connected to the second bonding part 122 through the second conductive layer 322 provided in the second opening part TH2.

Accordingly, the light emitting device 120 can be driven by a driving power supplied through the first bonding part 121 and the second bonding part 122. In addition, the light emitted from the light emitting device 120 may be directed in an upward direction of the package body 110.

Meanwhile, the light emitting device package 100 according to the embodiment described above may be mounted and provided on a sub-mount, a circuit board or the like.

However, when a conventional light emitting device package is mounted on a sub-mount, a circuit board or the like, a high temperature process such as a reflow process or a heat treatment process may be applied. In the reflow process or the heat treatment process, a re-melting phenomenon may occur in a bonding region between the lead frame provided in the light emitting device package and the light emitting device, thereby weakening stability of electrical connection and physical coupling.

However, according to the light emitting device package and the method of manufacturing the light emitting device package of an embodiment, the first bonding part 121 and the second bonding part 122 of the light emitting device 120 may receive the driving power through the first and second conductive layers 321 and 322. In addition, melting points of the first and second conductive layers 321 and 322 may be set to be values higher than a melting point of a typical bonding material.

Therefore, according to an embodiment, even if the light emitting device package 100 is bonded to a main substrate or the like through the reflow process, the re-melting phenomenon may not occur, so that the electrical connection and physical bonding strength may not be deteriorated.

In addition, according to the light emitting device package 100 and the method of manufacturing the light emitting device package of an embodiment, since the light emitting device 120 is mounted on the first body arrays A1, A2, A3, and A4 by using a conductive paste, the package body 110 does not need to be exposed at high temperatures in a process of manufacturing the light emitting device package. Therefore, according to an embodiment, it is possible to prevent the package body 110 from being damaged or discolored by exposing the package body 110 at high temperatures.

For example, the package body 110 may include at least one material selected from the group consisting of a PolyPhtalAmide (PPA) resin, a PolyCyclohexylenedimethylene Terephthalate (PCT) resin, an epoxy molding compound (EMC) resin, a silicone molding compound (SMC) resin, and a Poly Imide (PI) resin.

Hereinafter, a light emitting device package according to another embodiment of the present invention will be described with reference to FIG. 9. FIG. 8 is a view showing a light emitting device package according to another embodiment of the present invention.

The light emitting device package according to the embodiment of the present invention shown in FIG. 9 is an example in which the light emitting device package 100 described with reference to FIGS. 1 to 8 is mounted on a circuit board 310 and provided.

Upon describing the light emitting device package according to an embodiment of the present invention with reference to FIG. 9, the descriptions that overlap with those described with reference to FIGS. 1 to 8 may be omitted.

According to an embodiment, as shown in FIG. 9, the light emitting device package may include a circuit board 310, the package body 110, and the light emitting device 120.

The circuit board 310 may include a first pad 311, a second pad 312, and a support substrate 313. The support substrate 313 may be provided with a power supply circuit for controlling the driving of the light emitting device 120.

The package body 110 may be disposed on the circuit board 310. The first pad 311 and the first bonding part 121 may be electrically connected to each other. The second pad 312 and the second bonding part 122 may be electrically connected to each other.

The first pad 311 and the second pad 312 may include a conductive material. For example, the first pad 311 and the second pad 312 may include at least one material selected from the group consisting of Ti, Cu, Ni, Au, Cr, Ta, Pt, Sn, Ag, P, Fe, Sn, Zn and A1, or an alloy thereof. The first pad 311 and the second pad 312 may be prepared as a single layer or a multi-layer.

The package body 110 may include a first package body 113 and a second package body 117.

The package body 110 may include the first opening part TH1 and the second opening part TH2 provided in the first direction from an upper surface to a lower surface of the package body 110. The first opening part TH1 and the second opening part TH2 may be provided in the first direction from the upper surface to the lower surface of the first package body 113.

Meanwhile, according to an embodiment, the first package body 113 and the second package body 117 may include mutually different materials. For example, the first package body 113 and the second package body 117 may be formed of mutually different materials in mutually different processes, and then coupled to each other through the adhesive layer 160.

The adhesive layer 160 may be disposed between the first package body 113 and the second package body 117. The adhesive layer 160 may be disposed on the upper surface of the first package body 113. The adhesive layer 160 may be disposed on the lower surface of the second package body 117. The adhesive layer 160 may be disposed at a periphery of the light emitting device 120 to form the cavity.

The adhesive layer 160 may include at least one of an epoxy-based material, a silicone-based material, a hybrid material including the epoxy-based material and the silicone-based material. In addition, the adhesive layer 160 may reflect the light emitted from the light emitting device 120. If the adhesive layer 160 includes a reflection function, the adhesive may include white silicone.

Meanwhile, each of the first package body 113 and the second package body 117 may include at least one selected from resin materials including Polyphthalamide (PPA), Polychloro Tri phenyl (PCT), liquid crystal polymer (LCP), Polyamide9T (PA9T), silicone, an epoxy molding compound (EMC), a silicone molding compound (SMC), Poly Imide (PI), and the like as a base material.

In addition, each of the first package body 113 and the second package body 117 may include at least one of a reflective material and a wavelength conversion material. In addition, the first package body 113 and the second package body 117 may not include a reflective material and a wavelength conversion material.

The first package body 113 and the second package body 117 may include mutually different base materials.

For example, the first package body 113 may include a reflective material, and the second package body 117 may include a wavelength conversion material. In addition, the first package body 113 may include a wavelength conversion material, and the second package body 117 may include a reflective material.

According to an embodiment, the first package body 113 may include a reflective material, and the second package body 117 may include a reflective material and a wavelength conversion material. In addition, the first package body 113 may include a reflective material and a wavelength conversion material, and the second package body 117 may include a wavelength conversion material.

According to the light emitting device package 100 of an embodiment, the first package body 113 and the second package body 117 including mutually different base materials may be separately provided in mutually different processes, and manufactured in a modular scheme by selectively combining components to satisfy the characteristics required for applications.

The light emitting device 120 may include a first bonding part 121, a second bonding part 122, a light emitting structure 123, and a substrate 124.

The light emitting device 120 may be disposed on the package body 110. The light emitting device 120 may be disposed on the first package body 113. The light emitting device 120 may be disposed in the cavity C provided by the second package body 117.

The first bonding part 121 may be disposed on the lower surface of the light emitting device 120. The second bonding part 122 may be disposed on the lower surface of the light emitting device 120. The first bonding part 121 and the second bonding part 122 may be spaced apart from each other on the lower surface of the light emitting device 120.

The first bonding part 121 may be disposed between the light emitting structure 123 and the first package body 113. The second bonding part 122 may be disposed between the light emitting structure 123 and the first package body 113.

The first opening part TH1 may be arranged under the first bonding part 121 of the light emitting device 120. The first opening part TH1 may overlap with the first bonding part 121 of the light emitting device 120. The first opening part TH1 may overlap with the first bonding part 121 of the light emitting device 120 in the first direction, which is directed from the upper surface toward the lower surface of the first package body 113.

The second opening part TH2 may be arranged under the second bonding part 122 of the light emitting device 120. The second opening part TH2 may overlap with the second bonding part 122 of the light emitting device 120. The second opening part TH2 may overlap with the second bonding part 122 of the light emitting device 120 in the first direction, which is directed from the upper surface toward the lower surface of the first package body 113.

The first opening part TH1 and the second opening part TH2 may be spaced apart from each other. The first opening part TH1 and the second opening part TH2 may be spaced apart from each other under the lower surface of the light emitting device 120.

According to an embodiment, as shown in FIG. 9, the light emitting device package may include a first conductive layer 321 and a second conductive layer 322.

The first conductive layer 321 may be disposed in the first opening part TH1. The first conductive layer 321 may make direct contact with the lower surface of the first bonding part 121. The first conductive layer 321 may overlap with the first bonding part 121 in a vertical direction.

The upper surface of the first conductive layer 321 may be coplanar with the upper surface of the first package body 113. The lower surface of the first conductive layer 321 may be coplanar with the lower surface of the first package body 113.

The second conductive layer 322 may be disposed in the second opening part TH2. The second conductive layer 322 may make direct contact with the lower surface of the second bonding part 122. The second conductive layer 322 may overlap with the second bonding part 122 in a vertical direction.

The upper surface of the second conductive layer 322 may be coplanar with the upper surface of the first package body 113. The lower surface of the second conductive layer 322 may be coplanar with the lower surface of the first package body 113.

For example, the first conductive layer 321 and the second conductive layer 322 may include at least one material selected from the group consisting of Ag, Au, Pt, Sn, Cu, and the like, or an alloy thereof.

According to an embodiment, as shown in FIG. 9, the light emitting device package may include a metal layer 430.

The metal layer 430 may be disposed under the first and second conductive layers 321 and 322. The metal layer 430 may be disposed on the lower surfaces of the first and second conductive layers 321 and 322. In addition, according to an embodiment, the metal layer 430 may be provided on the lower surface of the first package body 113 adjacent to the first and second opening parts TH1 and TH2.

The metal layer 430 may be formed of at least one material selected from the group consisting of titanium (Ti), copper (Cu), nickel (Ni), gold (Au), chromium (Cr), tantalum (Ta), platinum (Pt), tin (Sn), silver (Ag), and phosphorous (P), or an alloy thereof.

According to an embodiment, the first pad 311 of the circuit board 310 and the first conductive layer 321 may be electrically connected to each other by the metal layer 430. In addition, the second pad 312 of the circuit board 310 and the second conductive layer 322 may be electrically connected to each other by the metal layer 430.

In addition, according to an embodiment, as shown in FIG. 9, the light emitting device package may include a recess R. The recess R may be concavely provided at the bottom surface of the cavity C toward the lower surface of the package body 110.

The recess R may be provided in the first package body 113. The recess R may be concavely provided in a direction from the upper surface to the lower surface of the first package body 113. The recess R may be arranged under the light emitting device 120.

The recess R may be arranged under the light emitting device 120 while being arranged between the first bonding part 121 and the second bonding part 122. The recess R may extend under the light emitting device 120 in the short axis direction of the light emitting device 120.

According to an embodiment, as shown in FIG. 9, the light emitting device package may include a first resin 130.

The first resin 130 may be disposed in the recess R. The first resin 130 may be disposed between the light emitting device 120 and the first package body 113. The first resin 130 may be disposed between the first bonding part 121 and the second bonding part 122. For example, the first resin 130 may make contact with the side surface of the first bonding part 121 and the side surface of the second bonding part 122.

The first resin 130 may be disposed at a periphery of the first bonding part 121 to seal the upper region of the first opening part TH1. The first resin 130 may be disposed at a periphery of the second bonding part 122 to seal the upper region of the second opening part TH1.

The first resin 130 may provide the stable fixing strength between the light emitting device 120 and the first package body 113. For example, the first resin 130 may make direct contact with the upper surface of the first package body 113. In addition, the first resin 130 may make direct contact with the lower surface of the light emitting device 120.

For example, the first resin 130 may include at least one of an epoxy-based material, a silicone-based material, a hybrid material including the epoxy-based material and the silicone-based material. In addition, the first resin 130 may reflect light emitted from the light emitting device 120. If the first resin 130 includes a reflection function, an adhesive may include white silicone. If the first resin 130 includes a reflection function, the first resin 130 may be, for example, formed of a material including TiO₂, SiO₂ or the like. The first resin 130 may be referred to as the adhesive.

According to an embodiment, the depth of the recess R may be smaller than the depth of the first opening part TH1 or the depth of the second opening part TH2.

The depth of the recess R may be determined in consideration of the adhesive strength of the first resin 130. In addition, the depth T1 of the recess R may be determined in consideration of the stable strength of the first package body 113 and/or determined to prevent a crack from being generated on the light emitting device package 100 due to heat emitted from the light emitting device 120.

The recess R may provide a space suitable for performing a sort of an under fill process at the lower portion of the light emitting device 120. The recess R may have a first depth or more to sufficiently provide the first resin 130 between the lower surface of the light emitting device 120 and the upper surface of the first package body 113. In addition, the recess R may have a second depth or less to provide stable strength to the first package body 113.

The depth and width of the recess R may influence a position and fixing strength of the first resin 130. The depth and width of the recess R may be determined such that sufficient fixing strength is provided by the first resin 130 disposed between the first package body 113 and the light emitting device 120.

For example, the depth of the recess R may be several tens of micrometers. The depth of the recess R may be 40 micrometers to 60 micrometers.

In addition, the width W3 of the recess R may be several hundreds of micrometers. The width W3 of the recess R may be 140 micrometers to 160 micrometers. For example, the width W3 of the recess may be 150 micrometers.

The depth of the first opening part TH1 may be determined corresponding to the thickness of the first package body 113. The depth of the first opening part TH1 may be determined such that the first package body 113 may maintain stable strength.

For example, the depth of the first opening part TH1 may be several hundreds of micrometers. The depth of the first opening part TH1 may be 180 micrometers to 220 micrometers. For example, the depth of the first opening part TH1 may be 200 micrometers.

For example, a thickness defined by subtracting the depth of the recess R from the depth of the first opening part TH1 may be set to be 100 micrometers or more. The above thickness is selected by taking into consideration a thickness for an injection molding process, which may allow the crack free of the first package body 113.

According to an embodiment, the depth of the first opening part TH1 may be 2 to 10 times based on the depth of the recess R. For example, if the depth of the first opening part TH1 is 200 micrometers, the depth of the recess R may be 20 micrometers to 100 micrometers.

In addition, according to an embodiment, as shown in FIG. 9, the light emitting device package may include a second resin 140.

The second resin 140 may be provided on the light emitting device 120. The second resin 140 may be disposed on the first package body 113. The second resin 140 may be disposed in the cavity C provided by the second package body 117.

According to the light emitting device package of an embodiment, as described with reference to FIG. 9, a conventional lead frame is not applied when the package body 110 is provided.

In the case of the light emitting device package to which the conventional lead frame is applied, an additional process of forming the lead frame is required. However, according to an embodiment of the present invention, the non-claimed method of manufacturing the light emitting device package does not require the process of forming the lead frame. Accordingly, according to the method of manufacturing the light emitting device package of an embodiment of the present invention, a process time can be shortened and a material can be reduced.

In addition, in the case of the light emitting device package to which the conventional lead frame is applied, it is necessary to add a plating process using silver or the like to prevent deterioration of the lead frame. However, according to the light emitting device package of an embodiment of the present invention, the lead frame is not required, so that an additional process such as a silver plating process can be omitted. Therefore, according to the light emitting device package of embodiments, there is no discoloration of a silver-plate material, and a manufacturing cost can be reduced by omitting the process. Therefore, according to the method of manufacturing the light emitting device package of an embodiment of the present invention, the manufacturing cost can be reduced, and the manufacturing yield and reliability of a product can be improved.

In addition, the light emitting device package according to an embodiment of the present invention can be miniaturized as compared with the light emitting device package to which the conventional lead frame is applied.

According to the light emitting device package 100 of an embodiment, a power source may be connected to the first bonding part 121 through the first conductive layer 321 provided in the first opening part TH1, and the power source may be connected to the second bonding part 122 through the second conductive layer 322 provided in the second opening part TH2.

Accordingly, the light emitting device 120 can be driven by a driving power supplied through the first bonding part 121 and the second bonding part 122. In addition, the light emitted from the light emitting device 120 may be directed in an upward direction of the package body 110.

Meanwhile, the light emitting device package 100 according to the embodiment described above may be mounted and provided on a sub-mount, a circuit board or the like.

However, when a conventional light emitting device package is mounted on a sub-mount, a circuit board or the like, a high temperature process such as a reflow process may be applied. In the reflow process, a re-melting phenomenon may occur in a bonding region between the lead frame provided in the light emitting device package and the light emitting device, thereby weakening stability of electrical connection and physical coupling.

However, according to the light emitting device package and the method of manufacturing the light emitting device package of an embodiment, the first bonding part 121 and the second bonding part 122 of the light emitting device 120 may receive the driving power through the first and second conductive layers 321 and 322. In addition, melting points of the first and second conductive layers 321 and 322 may be set to be values higher than a melting point of a typical bonding material.

Therefore, according to an embodiment, even if the light emitting device package 100 is bonded to a main substrate or the like through the reflow process, the re-melting phenomenon may not occur, so that the electrical connection and physical bonding strength may not be deteriorated.

In addition, according to the light emitting device package 100 and the method of manufacturing the light emitting device package of an embodiment, since the light emitting device 120 is mounted on the first body arrays A1, A2, A3, and A4 by using a conductive paste, the package body 110 does not need to be exposed at high temperatures in a process of manufacturing the light emitting device package. Therefore, according to an embodiment, it is possible to prevent the package body 110 from being damaged or discolored by exposing the package body 110 at high temperatures.

For example, the package body 110 may include at least one material selected from the group consisting of a PolyPhtalAmide (PPA) resin, a PolyCyclohexylenedimethylene Terephthalate (PCT) resin, an epoxy molding compound (EMC) resin, a silicone molding compound (SMC), and a Poly Imide (PI) resin.

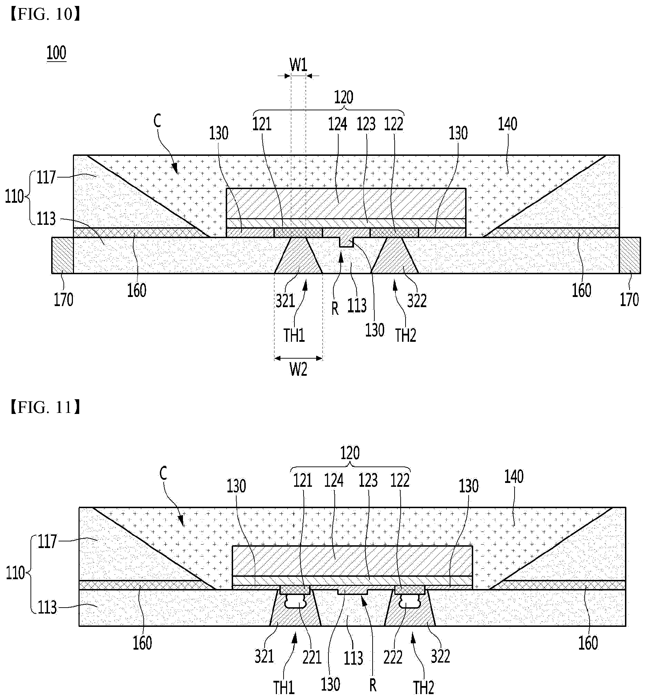

Meanwhile, FIG. 10 is a view showing a light emitting device package according to still another embodiment of the present invention. According to an embodiment, as shown in FIG. 10, the light emitting device package may further include a frame 170 as compared with the light emitting device package described with reference to FIGS. 1 to 9.

For example, the frame 170 may be disposed at both ends of the first package body 113. The frame 170 may provide a mechanical support structure to the package body 110. The frame 170 may be provided as an insulating support member. In addition, the frame 170 may be provided as a conductive support member.

Meanwhile, the light emitting device package according to the embodiment described above has been described based on a case where one opening part is provided under each bonding part.

However, according to the light emitting device package of another embodiment, a plurality of opening parts may be provided under each opening part. In addition, the opening parts may have mutually different widths.

In addition, according to an embodiment, the opening part may have various shapes.

For example, according to an embodiment, the opening part may have the same width from an upper region to a lower region of the opening part.

In addition, according to an embodiment, the opening part may be provided in the form of a multi-stage structure. For example, the opening part may be provided in the form of a two-stage structure having mutually different inclination angles. In addition, the opening part may be provided in the form of three stages or more having mutually different inclination angles.

In addition, the opening part may be provided in the form in which the width of the opening part changes from the upper region toward the lower region of the opening part. For example, the opening part may be provided in the form having a curvature from the upper region toward the lower region of the opening part.

In addition, according to the light emitting device package of an embodiment, the package body 110 may include only the first package body having a flat upper surface, and may exclude the second package body 117 disposed on the first package body 113.

Next, a light emitting device package according to the invention will be described with reference to FIG. 11.

FIG. 11 is a view showing a light emitting device package according to the present invention. While describing the light emitting device package according to an embodiment with reference to FIG. 11, the descriptions that overlap with those described with reference to FIG. 1 to 10 may be omitted.

According to the invention, as shown in FIG. 11, a light emitting device package includes a package body 110 and a light emitting device 120.

The package body 110 includes a first package body 113 and a second package body 117. The second package body 117 may be disposed on the first package body 113. The second package body 117 may be disposed at a periphery of an upper surface of the first package body 113. The second package body 117 may form a cavity C over the upper surface of the first package body 113.

According to an embodiment, the package body 110 may have a structure provided with the cavity C, or may have a structure provided with a flat upper surface without the cavity C.

For example, the package body 110 may be formed of one selected from the group consisting of Polyphthalamide (PPA), Polychloro Tri phenyl (PCT), liquid crystal polymer (LCP), Polyamide9T (PA9T), silicone, an epoxy molding compound (EMC), a silicone molding compound (SMC), ceramic, Poly Imide (PI), photo sensitive glass (PSG), a sapphire (Al₂O₃), and the like. In addition, the package body 110 may include a reflective material including a high refractive filler such as TiO₂ or SiO₂. The package body 110 may include a wavelength conversion material such as a quantum dot or a fluorescent substance.

Meanwhile, according to an embodiment, the first package body 113 and the second package body 117 may include mutually different materials. For example, the first package body 113 and the second package body 117 may be formed of mutually different materials in mutually different processes, and then coupled to each other by an adhesive layer 160.

The adhesive layer 160 is disposed between the first package body 113 and the second package body 117. The adhesive layer 160 may be disposed on the upper surface of the first package body 113. The adhesive layer 160 may be disposed on the lower surface of the second package body 117. The adhesive layer 160 is disposed at a periphery of the light emitting device 120 to form the cavity.

The adhesive layer 160 may include at least one of an epoxy-based material, a silicone-based material, a hybrid material including the epoxy-based material and the silicone-based material. In addition, the adhesive layer 160 may reflect the light emitted from the light emitting device 120. If the adhesive layer 160 includes a reflection function, the adhesive may include white silicone.

Meanwhile, each of the first package body 113 and the second package body 117 may include at least one selected from resin materials including Polyphthalamide (PPA), Polychloro Tri phenyl (PCT), liquid crystal polymer (LCP), Polyamide9T (PA9T), silicone, an epoxy molding compound (EMC), a silicone molding compound (SMC), Poly Imide (PI), and the like as a base material.

In addition, each of the first package body 113 and the second package body 117 may include at least one of a reflective material and a wavelength conversion material. In addition, the first package body 113 and the second package body 117 may not include a reflective material and a wavelength conversion material.

The first package body 113 and the second package body 117 may include mutually different base materials.

For example, the first package body 113 may include a reflective material, and the second package body 117 may include a wavelength conversion material. In addition, the first package body 113 may include a wavelength conversion material, and the second package body 117 may include a reflective material.

According to an embodiment, the first package body 113 may include a reflective material, and the second package body 117 may include a reflective material and a wavelength conversion material. In addition, the first package body 113 may include a reflective material and a wavelength conversion material, and the second package body 117 may include a wavelength conversion material.

According to the light emitting device package 100 of an embodiment, the first package body 113 and the second package body 117 including mutually different base materials may be separately provided in mutually different processes, and manufactured in a modular scheme by selectively combining components to satisfy the characteristics required for applications.

According to an embodiment, the light emitting device 120 may include a first bonding part 121, a second bonding part 122, a light emitting structure 123, and a substrate 124.

The light emitting device 120, as shown in FIG. 11, may include the light emitting structure 123 disposed under the substrate 124. The first bonding part 121 and the second bonding part 122 may be disposed between the light emitting structure 123 and the first package body 113.

The light emitting device 120 may be disposed on the package body 110. The light emitting device 120 may be disposed on the first package body 113. The light emitting device 120 may be disposed in the cavity C provided by the second package body 117.

The first bonding part 121 may be disposed on the lower surface of the light emitting device 120. The second bonding part 122 may be disposed on the lower surface of the light emitting device 120. The first bonding part 121 and the second bonding part 122 may be spaced apart from each other on the lower surface of the light emitting device 120.

The first bonding part 121 may be disposed between the light emitting structure 123 and the first package body 113. The second bonding part 122 may be disposed between the light emitting structure 123 and the first package body 113.

Meanwhile, according to an embodiment, as shown in FIG. 11, the light emitting device package may include a first opening part TH1 and a second opening part TH2.

The package body 110 may include the first opening part TH1 provided through the lower surface of the package body 110 in a bottom surface of the cavity C. The package body 110 may include the second opening part TH2 provided through the lower surface of the package body 110 in the bottom surface of the cavity C.

The first opening part TH1 may be arranged under the first bonding part 121 of the light emitting device 120. The first opening part TH1 may overlap with the first bonding part 121 of the light emitting device 120. The first opening part TH1 may overlap with the first bonding part 121 of the light emitting device 120 in the first direction, which is directed from the upper surface toward the lower surface of the first package body 113.

The second opening part TH2 may be provided in the first package body 113. The second opening part TH2 may be provided through the first package body 113. The second opening part TH2 may be provided through the upper surface and the lower surface of the first package body 113 in the first direction.

The second opening part TH2 may be arranged under the second bonding part 122 of the light emitting device 120. The second opening part TH2 may overlap with the second bonding part 122 of the light emitting device 120. The second opening part TH2 may overlap with the second bonding part 122 of the light emitting device 120 in the first direction, which is directed from the upper surface toward the lower surface of the first package body 113.

The first opening part TH1 and the second opening part TH2 may be spaced apart from each other. The first opening part TH1 and the second opening part TH2 may be spaced apart from each other under the lower surface of the light emitting device 120.

According to an embodiment, the width of the upper region of the first opening part TH1 may be larger than the width of the first bonding part 121. In addition, the width of the upper region of the second opening part TH2 may be larger than the width of the second bonding part 122.

According to an embodiment, the lower region of the first bonding part 121 may be disposed in the upper region of the first opening part TH1. A bottom surface of the first bonding part 121 may be disposed at a lower position than a position of a top surface of the first package body 113.

In addition, the lower region of the second bonding part 122 may be disposed in the upper region of the second opening part TH2. A bottom surface of the second bonding part 122 may be disposed at a lower position than the position of the top surface of the first package body 113.

The width of the upper region of the first opening part TH1 may be equal to or smaller than the width of the lower region of the first opening part TH1. The width of the upper region of the second opening part TH2 may be equal to or smaller than the width of the lower region of the second opening part TH2.

The first opening part TH1 may be inclined such that the width of the first opening part TH1 gradually decreases from the lower region toward the upper region of the first opening part TH1. The second opening part TH2 may be inclined such that the width of the second opening part TH2 gradually decreases from the lower region toward the upper region of the second opening part TH2.

However, embodiments are not limited thereto, and a plurality of inclined surfaces having mutually different slopes may be provided between the upper region and the lower region of the first and second opening parts TH1 and TH2, in which the inclined surfaces may have a curvature.

A width between the first opening part TH1 and the second opening part TH2 in a lower surface region of the first package body 113 may be several hundreds of micrometers. The width between the first opening part TH1 and the second opening part TH2 in the lower surface region of the first package body 113 may be 100 micrometers to 150 micrometers.

According to an embodiment, when the light emitting device package is later mounted on a circuit board, a sub-mount or the like, the width between the first opening part TH1 and the second opening part TH2 in the lower surface region of the first package body 113 may be set to be a predetermined distance or more in order to prevent an electrical short from occurring between the pads.

In addition, according to an embodiment, the light emitting device package may include a first resin 130.

The first resin 130 may be disposed between the first package body 113 and the light emitting device 120. The first resin 130 may be disposed between the upper surface of the first package body 113 and the lower surface of the light emitting device 120.

In addition, according to an embodiment, the light emitting device package may include a recess R. The recess R may be concavely provided at the bottom surface of the cavity C toward the lower surface of the package body 110.

The recess R may be provided in the first package body 113. The recess R may be concavely provided in a direction from the upper surface to the lower surface of the first package body 113. The recess R may be arranged under the light emitting device 120.

The recess R may be arranged under the light emitting device 120 while being arranged between the first bonding part 121 and the second bonding part 122. The recess R may extend under the light emitting device 120 in the short axis direction of the light emitting device 120.

The first resin 130 may be disposed in the recess R. The first resin 130 may be disposed between the light emitting device 120 and the first package body 113. The first resin 130 may be disposed between the first bonding part 121 and the second bonding part 122. For example, the first resin 130 may make contact with a side surface of the first bonding part 121 and a side surface of the second bonding part 122.

The first resin 130 may be disposed at a periphery of the first bonding part 121 to seal the upper region of the first opening part TH1. The first resin 130 may be disposed at a periphery of the second bonding part 122 to seal the upper region of the second opening part TH1.

The first resin 130 may provide stable fixing strength between the light emitting device 120 and the first package body 113. For example, the first resin 130 may make direct contact with the upper surface of the first package body 113. In addition, the first resin 130 may make direct contact with the lower surface of the light emitting device 120.

For example, the first resin 130 may include at least one of an epoxy-based material, a silicone-based material, a hybrid material including the epoxy-based material and the silicone-based material. In addition, the first resin 130 may reflect light emitted from the light emitting device 120. If the first resin 130 includes a reflection function, an adhesive may include white silicone. If the first resin 130 includes a reflection function, the first resin 130 may be, for example, formed of a material including TiO₂, SiO₂ or the like. The first resin 130 may be referred to as the adhesive.

According to an embodiment, a depth of the recess R may be smaller than a depth of the first opening part TH1 or a depth of the second opening part TH2.

The depth of the recess R may be determined in consideration of adhesive strength of the first resin 130. In addition, the depth T1 of the recess R may be determined in consideration of stable strength of the first package body 113 and/or determined to prevent a crack from being generated on the light emitting device package 100 due to heat emitted from the light emitting device 120.

The recess R may provide a space suitable for performing a sort of an under fill process at a lower portion of the light emitting device 120. The recess R may have a first depth or more to sufficiently provide the first resin 130 between the lower surface of the light emitting device 120 and the upper surface of the first package body 113. In addition, the recess R may have a second depth or less to provide stable strength to the first package body 113.

The depth and a width of the recess R may influence a position and fixing strength of the first resin 130. The depth and width W3 of the recess R may be determined such that sufficient fixing strength is provided by the first resin 130 disposed between the first package body 113 and the light emitting device 120.

For example, the depth of the recess R may be several tens of micrometers. The depth of the recess R may be 40 micrometers to 60 micrometers.

In addition, the width of the recess R may be several hundreds of micrometers. The width W3 of the recess R may be 140 micrometers to 160 micrometers. For example, the width W3 of the recess may be 150 micrometers.

The depth of the first opening part TH1 may be determined corresponding to a thickness of the first package body 113. The depth of the first opening part TH1 may be determined such that the first package body 113 may maintain stable strength.

For example, the depth of the first opening part TH1 may be several hundreds of micrometers. The depth of the first opening part TH1 may be 180 micrometers to 220 micrometers. For example, the depth of the first opening part TH1 may be 200 micrometers.

For example, a thickness defined by subtracting the depth of the recess R from the depth of the first opening part TH1 may be set to be 100 micrometers or more. The above thickness is selected by taking into consideration a thickness for an injection molding process, which may allow the crack free of the first package body 113.

According to an embodiment, the depth of the first opening part TH1 may be 2 to 10 times based on the depth of the recess R. For example, if the depth of the first opening part TH1 is 200 micrometers, the depth of the recess R may be 20 micrometers to 100 micrometers.

In addition, according to an embodiment, the sum of areas of the first and second bonding parts 121 and 122 may be 10% or less of an area of an upper surface of the substrate 124. According to the light emitting device package of an embodiment, in order to increase the light extraction efficiency by ensuring a light emission area where light is emitted from the light emitting device, the sum of the areas of the first and second bonding parts 121 and 122 may be set to be 10% or less of the area of the upper surface of the substrate 124.

In addition, according to an embodiment, the sum of the areas of the first and second bonding parts 121 and 122 may be 0.7% or more of the area of the upper surface of the substrate 124. According to the light emitting device package of an embodiment, in order to provide stable bonding strength to the mounted light emitting device, the sum of the areas of the first and second bonding parts 121 and 122 may be set to be 0.7% or more of the area of the upper surface of the substrate 124.

Since the areas of the first and second bonding parts 121 and 122 are small as described above, an amount of light transmitted to the lower surface of the light emitting device 120 may be increased. In addition, the first resin 130 having a good reflection property may be provided under the light emitting device 120. Therefore, the light emitted in a downward direction of the light emitting device 120 is reflected by the first resin 130 and effectively discharged in an upward direction of the light emitting device package, and the light extraction efficiency can be improved.

In addition, according to an embodiment, as shown in FIG. 11, the light emitting device package may include a second resin 140.

The second resin 140 may be provided on the light emitting device 120. The second resin 140 may be disposed on the first package body 113. The second resin 140 may be disposed in the cavity C provided by the second package body 117.

The second resin 140 may include an insulating material. In addition, the second resin 140 may include a wavelength conversion material for receiving light emitted from the light emitting device 120 to provide wavelength-converted light. For example, the second resin 140 may include a fluorescent substance, a quantum dot or the like.

According to the invention as shown in FIG. 11, the light emitting device package includes a first conductor 221 and a second conductor 222. In addition, the light emitting device package includes a first conductive layer 321 and a second conductive layer 322. The first conductive layer 321 is spaced apart from the second conductive layer 322.

The first conductor 221 is disposed under the first bonding part 121. The first conductor 221 is electrically connected to the first bonding part 121. The first conductor 221 overlaps with the first bonding part 121 in the first direction.

The first conductor 221 is provided in the first opening part TH1. The first conductor 221 is disposed between the first bonding part 121 and the first conductive layer 321. The first conductor 221 is electrically connected to the first bonding part 121 and the first conductive layer 321.

A lower surface of the first conductor 221 is disposed at a lower position than a position of the upper surface of the first opening part TH1. The lower surface of the first conductor 221 is disposed at a lower position than a position of the upper surface of the first conductive layer 321.

The first conductor 221 is disposed on the first opening part TH1. In addition, the first conductor 221 extends from the first bonding part 121 to an inside of the first opening part TH1.

In addition, the second conductor 222 is disposed under the second bonding part 122. The second conductor 222 is electrically connected to the second bonding part 122. The second conductor 222 overlaps with the second bonding part 122 in the first direction.

The second conductor 222 is provided in the second opening part TH2. The second conductor 222 is disposed between the second bonding part 122 and the second conductive layer 322. The second conductor 222 is electrically connected to the second bonding part 122 and the second conductive layer 322.

A lower surface of the second conductor 222 is disposed at a lower position than a position of the upper surface of the second opening part TH2. The lower surface of the second conductor 222 is disposed at a lower position than a position of the upper surface of the second conductive layer 322.

The second conductor 222 is disposed on the second opening part TH2. In addition, the second conductor 222 extends from the second bonding part 122 to an inside of the second opening part TH2.

According to the invention, the first conductive layer 321 is disposed on the lower surface and a side surface of the first conductor 221. The first conductive layer 321 contacts with the lower surface and the side surface of the first conductor 221.

The first conductive layer 321 is provided in the first opening part TH1. The first conductive layer 321 is disposed under the first bonding part 121. The width of the first conductive layer 321 is larger than the width of the first bonding part 121.

According to the light emitting device package of the embodiment as described above, the electrical connection between the first conductive layer 321 and the first bonding part 121 can be stably provided by the first conductor 221.

In addition, according to an embodiment, the second conductive layer 322 may be disposed on the lower surface and a side surface of the second conductor 222. The second conductive layer 322 may make contact with the lower surface and the side surface of the second conductor 222.

The second conductive layer 322 may be provided in the second opening part

TH2. The second conductive layer 322 may be disposed under the second bonding part 122. The width of the second conductive layer 322 may be larger than the width of the second bonding part 122.

According to the light emitting device package of the embodiment as described above, the electrical connection between the second conductive layer 322 and the second bonding part 122 can be stably provided by the second conductor 222.

For example, the first and second conductors 221 and 222 may be stably bonded to the first and second bonding parts 121 and 122 through separate bonding materials, respectively. In addition, the side surfaces and the lower surfaces of the first and second conductors 221 and 222 may make contact with the first and second conductive layers 321 and 322, respectively. Therefore, as compared with a case where the first and second conductive layers 321 and 322 make direct contact with the lower surfaces of the first and second bonding parts 121 and 122, areas of the first and second conductive layers 321 and 322 respectively making contact with the first and second conductors 221 and 222 may become larger. Accordingly, power can be stably supplied from the first and second conductive layers 321 and 322 to the first and second bonding parts 121 and 122 through the first and second conductors 221 and 222, respectively.

For example, the first and second conductors 221 and 222 may be formed of at least one material selected from the group consisting of Al, Au, Ag, Pt, and the like, or an alloy thereof. In addition, each of the first and second conductors 221 and 222 may be prepared as a single layer or a multi-layer.

The first bonding part 121 may have a width defined in a second direction perpendicular to the first direction along which the first opening part TH1 is provided. The width of the first bonding part 121 may be smaller than the width of the first opening part TH1 in the second direction.

The first conductive layer 321 may make direct contact with the lower surface of the first bonding part 121. The first conductive layer 321 may be electrically connected to the first bonding part 121. The first conductive layer 321 may be surrounded by the first package body 113.

In the upper region of the first opening part TH1, an upper portion of the first conductive layer 321 may be disposed around a lower portion of the first bonding part 121. The upper surface of the first conductive layer 321 may be disposed at a higher position than a positon of the lower surface of the first bonding part 121.

The second conductive layer 322 may be provided in the second opening part TH2. The second conductive layer 322 may be disposed under the second bonding part 122. The width of the second conductive layer 322 may be larger than the width of the second bonding part 122.

The second bonding part 122 may have a width defined in the second direction perpendicular to the first direction along which the second opening part TH2 is provided. The width of the second bonding part 122 may be smaller than the width of the second opening part TH2 in the second direction.

The second conductive layer 322 may make direct contact with the lower surface of the second bonding part 122. The second conductive layer 322 may be electrically connected to the second bonding part 122. The second conductive layer 322 may be surrounded by the first package body 113.

In the upper region of the second opening part TH2, an upper portion of the second conductive layer 322 may be disposed around a lower portion of the second bonding part 122. The upper surface of the second conductive layer 322 may be disposed at a higher position than a positon of the lower surface of the second bonding part 122.

The first conductive layer 321 and the second conductive layer 322 may include at least one material selected from the group consisting of Ag, Au, Pt, Sn, Cu, and the like, or an alloy thereof. However, embodiments are not limited thereto, and the first conductive layer 321 and the second conductive layer 322 may be formed of a material capable of ensuring a conductive function.

For example, the first conductive layer 321 and the second conductive layer 322 may be formed of a conductive paste. The conductive paste may include a solder paste, a silver paste or the like, and may be prepared as a multi-layer formed of mutually different materials, or a multi-layer or a single layer formed of an alloy. For example, the first conductive layer 321 and the second conductive layer 322 may include a SnAg-Cu (SAC) material.

According to an embodiment, the first conductive layer 321 may be electrically connected to the first bonding part 121, and the second conductive layer 322 may be electrically connected to the second bonding part 122. For example, external power may be supplied to the first conductive layer 321 and the second conductive layer 322, thereby driving the light emitting device 120.

The first resin 130 may perform a function of stably fixing the light emitting device 120 to the package body 110. In addition, the first resin 130 may be disposed at a periphery of the first and second bonding parts 121 and 122 while making contact with the side surfaces of the first and second bonding parts 121 and 122. When viewed from the top of the light emitting device 120, the first resin 130 is disposed such that the first and second opening parts TH1 and TH2 are isolated from an outer region where the second resin 140 is provided.

Due to the first resin 130, the first and second conductive layers 321 and 322 respectively provided in the first and second opening parts TH1 and TH2 may be prevented from flowing outward of the light emitting device 120.

When viewed from the top of the light emitting device 120, if the first and second conductive layers 321 and 322 move outward of the light emitting device 120, the first and second conductive layers 321 and 322 may be diffused along a side surface of the light emitting device 120. If the first and second conductive layers 321 and 322 move to the side surface of the light emitting device 120 as described above, the first conductive semiconductor layer and the second conductive semiconductor layer of the light emitting device 120 may be electrically short-circuited. In addition, if the first and second conductive layers 321 and 322 move to the side surface of the light emitting device 120, light extraction efficiency of the light emitting device 120 may be reduced.

However, according to an embodiment, since peripheral regions of the first and second bonding parts 121 and 122 can be sealed by the first resin 130, the first and second conductive layers 321 and 322 may be prevented from overflowing outward of regions of the first and second opening parts TH1 and TH2.

Therefore, according to the light emitting device package 100 of an embodiment, the first and second conductive layers 321 and 322 can be prevented from moving to the side surface of the light emitting device 120, the light emitting device 120 can be prevented from being electrically short-circuited, and the light extraction efficiency can be improved.

According to the light emitting device package of an embodiment, as described with reference to FIG. 11, a conventional lead frame is not applied when the package body 110 is provided.

In the case of the light emitting device package to which the conventional lead frame is applied, an additional process of forming the lead frame is required. However, according to an embodiment of the present invention, the non-claimed method of manufacturing the light emitting device package does not require the process of forming the lead frame. Accordingly, according to the method of manufacturing the light emitting device package of an embodiment of the present invention, a process time can be shortened and a material can be reduced.

In addition, in the case of the light emitting device package to which the conventional lead frame is applied, it is necessary to add a plating process using silver or the like to prevent deterioration of the lead frame. However, according to the method of manufacturing the light emitting device package of an embodiment of the present invention, the lead frame is not required, so that an additional process such as a silver plating process is unnecessary. Accordingly, according to the method of manufacturing the light emitting device package of an embodiment of the present invention, a manufacturing cost may be reduced and a manufacturing yield may be improved.

In addition, the light emitting device package according to an embodiment of the present invention can be miniaturized as compared with the light emitting device package to which the conventional lead frame is applied.

According to the light emitting device package 100 of an embodiment, a power source may be connected to the first bonding part 121 through the first conductive layer 321 provided in the first opening part TH1, and the power source may be connected to the second bonding part 122 through the second conductive layer 322 provided in the second opening part TH2.

Accordingly, the light emitting device 120 can be driven by a driving power supplied through the first bonding part 121 and the second bonding part 122. In addition, the light emitted from the light emitting device 120 may be directed in an upward direction of the package body 110.

Meanwhile, the light emitting device package according to the embodiment described above may be mounted and provided on a sub-mount, a circuit board or the like.

However, when a conventional light emitting device package is mounted on a sub-mount, a circuit board or the like, a high temperature process such as a reflow process or a heat treatment process may be applied. In the reflow process or the heat treatment process, a re-melting phenomenon may occur in a bonding region between the lead frame provided in the light emitting device package and the light emitting device, thereby weakening stability of electrical connection and physical coupling.

However, according to the light emitting device package and the non-claimed method of manufacturing the light emitting device package of an embodiment, the bonding part of the light emitting device may receive the driving power through the conductive layer disposed in the opening part. In addition, a melting point of the conductive layer disposed in the opening part may be set to be a value higher than a melting point of a typical bonding material.

Therefore, according to an embodiment, even if the light emitting device package is bonded to a main substrate or the like through the reflow process, the re-melting phenomenon may not occur, so that the electrical connection and physical bonding strength may not be deteriorated.

In addition, according to the light emitting device package and the method of manufacturing the light emitting device package of an embodiment, the package body 110 does not need to be exposed at high temperatures in a process of manufacturing the light emitting device package. Therefore, according to an embodiment, it is possible to prevent the package body 110 from being damaged or discolored by exposing the package body 110 at high temperatures.

Accordingly, materials constituting the first package body 113 can be variously selected. According to an embodiment, the first package body 113 may be formed of expensive materials such as ceramic, and relatively inexpensive resin materials.

For example, the first package body 113 may include at least one material selected from the group consisting of a PolyPhtalAmide (PPA) resin, a PolyCyclohexylenedimethylene Terephthalate (PCT) resin, an epoxy molding compound (EMC) resin, a silicone molding compound (SMC) resin, and a Poly Imide (PI) resin.

Hereinafter, an example of the flip chip light emitting device applied to the light emitting device package according to the embodiment of the present invention will be described with reference to the accompanying drawings.

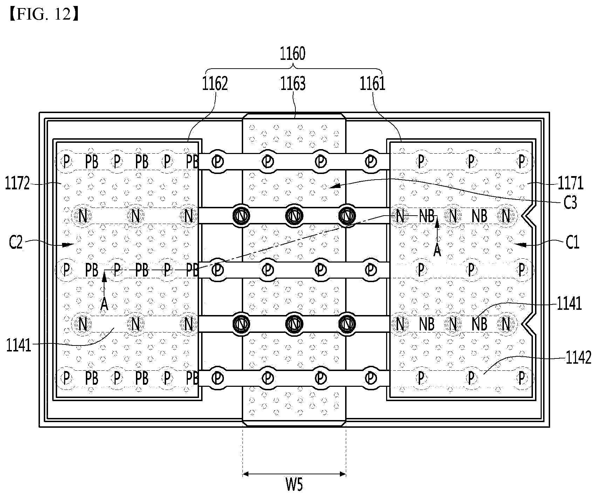

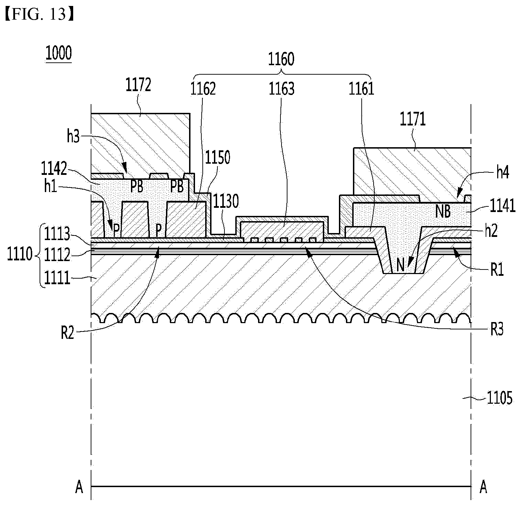

FIG. 12 is a plan view illustrating a light emitting device according to an embodiment of the present invention, and FIG. 13 is a sectional view taken along the line A-A of a light emitting device shown in FIG. 12.

For better understanding, though disposed under the first bonding part 1171 and the second bonding part 1172, FIG. 12 shows a first sub-electrode 1141 electrically connected to the first bonding part 1171, and a second sub-electrode 1142 electrically connected to the second bonding part 1172.

As shown in FIGS. 122 and 13, the light emitting device 1100 according to the embodiment may include a light emitting structure 1110 disposed on a substrate 1105.

The substrate 1105 may be selected from the group including a sapphire substrate (Al2O3), SiC, GaAs, GaN, ZnO, Si, GaP, InP and Ge. For example, the substrate 1105 may be provided as a patterned sapphire substrate (PSS) formed on an upper surface thereof with a concavo-convex pattern.

The light emitting structure 1110 may include a first conductive semiconductor layer 1111, an active layer 1112, and a second conductive semiconductor layer 1113. The active layer 1112 may be disposed between the first conductive semiconductor layer 1111 and the second conductive semiconductor layer 1113. For example, the active layer 1112 may be disposed on the first conductive semiconductor layer 1111, and the second conductive semiconductor layer 1113 may be disposed on the active layer 1112.

According to the embodiment, the first conductive semiconductor layer 1111 may be provided as an n-type semiconductor layer, and the second conductive semiconductor layer 1113 may be provided as a p-type semiconductor layer. According to another embodiment, the first conductive semiconductor layer 1111 may be provided as a p-type semiconductor layer, and the second conductive semiconductor layer 1113 may be provided as an n-type semiconductor layer.

Hereinafter, for the descriptive convenience, it will be described with reference to the case that the first conductive semiconductor layer 1111 is provided as an n-type semiconductor layer and the second conductive semiconductor layer 1113 is provided as a p-type semiconductor layer.

As shown in FIG. 13, the light emitting device 1100 according to the embodiment may include a transparent electrode layer 1130. The transparent electrode layer 1130 may increase light output by improving a current diffusion.

For example, the transparent electrode layer 1130 may include at least one selected from the group including a metal, metal oxide, and metal nitride. The transparent electrode layer 1130 may include a light transmissive material.

The transparent electrode layer 1130 may include selected from the group including indium tin oxide (ITO), indium zinc oxide (IZO), IZO nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IrOx, RuOx, RuOx/ITO, Ni/IrOx/Au, Ni/IrOx/Au/ITO, Pt, Ni, Au, Rh, and Pd.

As shown in FIGS. 12 and 13, the light emitting device 1100 according to the embodiment may include a reflective layer 1160. The reflective layer 1160 may include a first reflective layer 1161, a second reflective layer 1162, and a third reflective layer 1163. The reflective layer 1160 may be disposed on the transparent electrode layer 1130.

The second reflective layer 1162 may include a first opening h1 for exposing the transparent electrode layer 1130. The second reflective layer 1162 may include a plurality of first openings h1 disposed on the transparent electrode layer 1130.

The first reflective layer 1161 may include second openings h2 for exposing an upper surface of the first conductive semiconductor layer 1111.

The third reflective layer 1163 may be disposed between the first reflective layer 1161 and the second reflective layer 1162. For example, the third reflective layer 1163 may be connected to the first reflective layer 1161. In addition, the third reflective layer 1163 may be connected to the second reflective layer 1162. The third reflective layer 1163 may be disposed while physically making direct contact with the first reflective layer 1161 and the second reflective layer 1162.

The reflective layer 1160 according to the embodiment may make contact with the second conductive semiconductor layer 1113 through contact holes provided in the transparent electrode layer 1130. The reflective layer 1160 may physically make contact with an upper surface of the second conductive semiconductor layer 1113 through the contact holes provided in the transparent electrode layer 1130.

The reflective layer 1160 may be provided as an insulating reflective layer. For example, the reflective layer 1160 may be provided as a distributed bragg reflector (DBR) layer. In addition, the reflective layer 1160 may be provided as an omni directional reflector (ODR) layer. In addition, the reflective layer 1160 may be provided by stacking the DBR layer and the ODR layer.

As shown in FIGS. 12 and 13, the light emitting device 1100 according to the embodiment may include the first sub-electrode 1141 and the second sub-electrode 1142.

The first sub-electrode 1141 may be electrically connected to the first conductive semiconductor layer 1111 in the second opening h2. The first sub-electrode 1141 may be disposed on the first conductive semiconductor layer 1111. For example, according to the light emitting device 1100 of the embodiment, the first sub-electrode 1141 may be disposed on the upper surface of the first conductive semiconductor layer 1111 in the recess provided to a partial region of the first conductive semiconductor layer 1111 through the second conductive semiconductor layer 1113 and the active layer 1112.

The first sub-electrode 1141 may be electrically connected to the upper surface of the first conductive semiconductor layer 1111 through the second opening h2 provided in the first reflective layer 1161. The second opening h2 and the recess may vertically overlap each other. For example, as shown in FIGS. 24 and 25, the first sub-electrode 1141 may make direct contact with the upper surface of the first conductive semiconductor layer 1111 in recess regions.

The second sub-electrode 1142 may be electrically connected to the second conductive semiconductor layer 1113. The second sub-electrode 1142 may be disposed on the second conductive semiconductor layer 1113. According to the embodiment, the transparent electrode layer 1130 may be disposed between the second sub-electrode 1142 and the second conductive semiconductor layer 1113.

The second sub-electrode 1142 may be electrically connected to the second conductive semiconductor layer 1113 through the first opening h1 provided in the second reflective layer 1162. For example, as shown in FIGS. 31 and 32, the second sub-electrode 1142 may be electrically connected to the second conductive semiconductor layer 1113 through the transparent electrode layer 1130 in P regions.

As shown in FIGS. 12 and 13, the second sub-electrode 1142 may make direct contact with an upper surface of the transparent electrode layer 1130 through a plurality of first openings h1 provided in the second reflective layer 1162 in the P regions.

According to the embodiment, as shown in FIGS. 12 and 13, the first sub-electrode 1141 and the second sub-electrode 1142 may have polarities to each other and may be spaced apart from each other.

For example, the first sub-electrode 1141 may be provided in line shapes. In addition, for example, the second sub-electrode 1142 may be provided in line shapes. The first sub-electrode 1141 may be disposed between neighboring second sub-electrodes 1142. The second sub-electrode 1142 may be disposed between neighboring first sub-electrodes 1141.

When the first sub-electrode 1141 and the second sub-electrode 1142 have polarities different from each other, the number of the electrodes may be different from each other. For example, when the first sub-electrode 1141 is configured to be an n-electrode and the second sub-electrode 1142 be a p-electrode, the number of the second sub-electrodes 1142 may be more. When an electrical conductivity and/or resistance of the second conductive semiconductor layer 1113 and the first conductive semiconductor layer 1111 are different from each other, electrons injected into the light emitting structure 1110 may be balanced with positive holes by the first sub-electrode 1141 and the second sub electrode 1142, thus optical characteristics of the light emitting device may be improved.

Meanwhile, polarities of a first sub-electrode 1141 and a second sub-electrode 1142 may be opposite to each other depending on characteristics required in the light emitting device package to which the light emitting device according to the embodiment is applied. In addition, the width, length, shape, and number of the first sub-electrode 1141 and the second sub-electrode 1142 may be variously modified according to the characteristics required in the light emitting device package.

The first sub-electrode 1141 and the second sub-electrode 1142 may be provided with a structure having a single layer or multiple layers. For example, the first sub-electrode 1141 and the second sub-electrode 1142 may be ohmic electrodes. For example, the first sub-electrode 1141 and the second sub-electrode 1142 may include at least one or an alloy formed of at least two of ZnO, IrOx, RuOx, NiO, RuOx/ITO, Ni/IrOx/Au, Ni/IrOx/Au/ITO, Ag, Ni, Cr, Ti, Al, Rh, Pd, Ir, Ru, Mg, Zn, Pt, Au, and Hf.

As shown in FIGS. 12 and 13, the light emitting device 1100 according to the embodiment may include a protective layer 1150.

The protective layer 1150 may include third openings h3 for exposing the second sub-electrode 1142. The third openings h3 may be disposed corresponding to PB regions provided in the second sub-electrode 1142.

In addition, the protective layer 1150 may include fourth openings h4 for exposing the first sub-electrode 1141. The fourth openings h4 may be disposed corresponding to NB regions provided in the first sub-electrode 1141.

The protective layer 1150 may be disposed on the reflective layer 1160. The protective layer 1150 may be disposed on the first reflective layer 1161, the second reflective layer 1162, and the third reflective layer 1163.

For example, the protective layer 1150 may be provided as an insulating material. For example, the protective layer 1150 may be formed of at least one material selected from the group including SixOy, SiOxNy, SixNy, and AlxOy.

As shown in FIGS. 12 and 13, the light emitting device 1100 according to the embodiment may include the first bonding part 1171 and the second bonding part 1172 disposed on the protective layer 1150.

The first bonding part 1171 may be disposed on the first reflective layer 1161. In addition, the second bonding part 1172 may be disposed on the second reflective layer 1162. The second bonding part 1172 may be spaced apart from the first bonding part 1171.

The first bonding part 1171 may make contact with an upper surface of the first sub-electrode 1141 through the fourth openings h4 provided in the protective layer 1150 in the NB regions. The NB regions may be vertically offset with the second opening h2. When the plurality of NB regions and the second opening h2 are vertically offset from each other, a current injected into the first bonding part 1171 may be uniformly distributed in a horizontal direction of the first sub-electrode 1141, thus the current may be uniformly injected in the NB regions.

In addition, the second bonding part 1172 may make contact with an upper surface of the second sub-electrode 1142 through the third openings h3 provided in the protective layer 1150 in the PB regions. When the PB regions and the first openings h1 are not vertically overlapped with each other, a current injected into the second bonding part 1172 may be uniformly distributed in a horizontal direction of the second sub-electrode 1142, thus the current may be uniformly injected in the PB regions.

Thus, according to the light emitting device 1100 of the embodiment, the first bonding part 1171 may make contact with the first sub-electrode 1141 in the fourth openings h4. In addition, the second bonding part 1172 may make contact with the second sub-electrode 1142 in the multiple regions. Thus, according to the embodiment, because the power may be supplied through the regions, a current dispersion effect can be generated and an operating voltage can be reduced according to the increase of a contact area and the dispersion of a contact region.

In addition, according to the light emitting device 1100 of the embodiment, as shown in FIG. 13, the first reflective layer 1161 is disposed under the first sub-electrode 1141 and the second reflective layer 1162 is disposed under the second sub-electrode 1142. Accordingly, the first reflective layer 1161 and the second reflective layer 1162 reflect light emitted from the active layer 1112 of the light emitting structure 1110 to minimize the optical absorption in the first sub-electrode 1141 and the second sub-electrode 1142, so that light intensity Po can be improved.

For example, the first reflective layer 1161 and the second reflective layer 1162 may be formed of an insulating material, and have a structure such as a DBR structure using a material having high reflectivity so as to reflect the light emitted from the active layer 1112.

The first reflective layer 1161 and the second reflective layer 1162 may have a DBR structure in which materials having different refractive indexes are alternately disposed. For example, the first reflective layer 1161 and the second reflective layer 1162 may be disposed in a single layer or a stacked structure including at least one of TiO₂, SiO₂, Ta₂O₅, and HfO₂.

Without the limitation thereto, according to another embodiment, the first reflective layer 1161 and the second reflective layer 1162 may freely selected to adjust the reflectivity to the light emitted from the active layer 1112 according to a wavelength of the light emitted from the active layer 1112.

In addition, according to another embodiment, the first reflective layer 1161 and the second reflective layer 1162 may be provided as the ODR layer. According to still another embodiment, the first reflective layer 1161 and the second reflective layer 1162 may be provided as a sort of hybrid type in which the DBR layer and the ODR layer are stacked.

When the light emitting device according to the embodiment is implemented as a light emitting device package after being mounted by a flip chip bonding scheme, light provided from the light emitting structure 1110 may be emitted through the substrate 1105. The light emitted from the light emitting structure 1110 may be reflected by the first reflective layer 1161 and the second reflective layer 1162 and emitted toward the substrate 1105.

In addition, the light emitted from the light emitting structure 1110 may be emitted in the lateral direction of the light emitting structure 1110. In addition, the light emitted from the light emitting structure 1110 may be emitted to the outside through a region where the first bonding part 1171 and the second bonding part 1172 are not provided among surfaces on which the first bonding part 1171 and the second bonding part 1172 are disposed.

Specifically, the light emitted from the light emitting structure 1110 may be emitted to the outside through a region where the third reflective layer 1163 is not provided among the surfaces on which the first bonding part 1171 and the second bonding part 1172 are disposed.

Accordingly, the light emitting device 1100 according to the embodiment may emit the light in six-surfaced directions surrounding the light emitting structure 1110, and remarkably improve the light intensity.

Meanwhile, according to the light emitting device of the embodiment, when viewed from the top of the light emitting device 1100, the sum of the areas of the first bonding part 1171 and the second bonding part 1172 is less than or equal to 60% of the total area of the upper surface of the light emitting device 1100 on which the first bonding part 1171 and the second bonding part 1172 are disposed.

For example, the total area of the upper surface of the light emitting device 1100 may correspond to the area defined by a lateral length and a longitudinal length of the lower surface of the first conductive semiconductor layer 1111 of the light emitting structure 1110. In addition, the total area of the upper surface of the light emitting device 1100 may correspond to the area of an upper surface or a lower surface of the substrate 1105.

Accordingly, the sum of the areas of the first bonding part 1171 and the second bonding part 1172 is equal to or less than 60% of the total area of the light emitting device 1100, so that the amount of light emitted to the surface on which the first bonding part 1171 and the second bonding part 1172 are disposed may be increased. Thus, according to the embodiment, because the amount of the light emitted in the six-surfaced directions of the light emitting device 1100 is increased, the light extraction efficiency may be improved and the light intensity Po may be increased.

In addition, when viewed from the top of the light emitting device, the sum of the areas of the first bonding part 1171 and the second bonding part 1172 is equal to or greater than 30% of the total area of the light emitting device 1100.

Accordingly, the sum of the areas of the first bonding part 1171 and the second bonding part 1172 is equal to or greater than 30% of the total area of the light emitting device 1100, so that a stable mount may be performed through the first bonding part 1171 and the second bonding part 1172, and electrical characteristics of the light emitting device 1100 may be ensured.

The sum of the areas of the first bonding part 1171 and the second bonding part 1172 may be selected as 30% to 60% with respect to the total area of the light emitting device 1100 in consideration of ensuring the light extraction efficiency and the bonding stability.

In other words, when the sum of the areas of the first bonding part 1171 and the second bonding part 1172 is 30% to 100% with respect to the total area of the light emitting device 1100, the electrical characteristics of the light emitting device 1100 may be ensured and bonding strength to be mounted on the light emitting device package may be ensured, so that stable mount may be performed.

In addition, when the sum of the areas of the first bonding part 1171 and the second bonding part 1172 is more than 0% and equal to or less than 60% of the total area of the light emitting device 1100, the amount of light emitted to the surface on which the first bonding part 1171 and the second bonding part 1172 are disposed increases, so that the light extraction efficiency of the light emitting device 1100 may be improved and the light intensity Po may be increased.

In the embodiment, the sum of the areas of the first bonding part 1171 and the second bonding part 1172 is selected as 30% to 60% of the total area of the light emitting device 1100 so as to ensure the electrical characteristics of the light emitting device 1100 and the bonding strength to be mounted on the light emitting device package and increase the light intensity.

In addition, according to the light emitting device 1100 of the embodiment, the third reflective layer 1163 may be disposed between the first bonding part 1171 and the second bonding part 1172. For example, the length W5 of the third reflective layer 1163 in major axial direction of the light emitting device 1100 may correspond to the distance between the first bonding part 1171 and the second bonding part 1172. In addition, for example, the area of the third reflective layer 1163 may be 10% to 25% of the entire upper surface of the light emitting device 1100.

When the area of the third reflective layer 1163 is 10% or more of the entire upper surface of the light emitting device 1100, the package body disposed under the light emitting device may be prevented from being discolored or cracked. When being 25% or less, it is advantageous to ensure the light extraction efficiency for emitting light to six surfaces of the light emitting device.

In addition, without limited thereto in another embodiment, the area of the third reflective layer 1163 may be arranged to more than 0% and less than 10% of the entire upper surface of the light emitting device 1100 to ensure the light extraction efficiency more, and the area of the third reflective layer 1163 may be arranged to more than 25% and less than 100% of the entire upper surface of the light emitting device 1100 to prevent the package body from being discolored or cracked.

In addition, the light generated from the light emitting structure 1110 may be transmitted and emitted through a second region provided between a side surface arranged in the major axial direction and the first bonding part 1171 or the second bonding part 1172 adjacent to the side surface.

In addition, the light generated from the light emitting structure 1110 may be transmitted and emitted through a third region provided between a side surface arranged in a minor axial direction and the first bonding part 1171 or the second bonding part 1172 adjacent to the side surface.

According to the embodiment, the size of the first reflective layer 1161 may be several micrometers larger than the size of the first bonding part 1171. For example, the area of the first reflective layer 1161 may be provided in a size to completely cover the area of the first bonding part 1171. In consideration of a process error, for example, the length of one side of the first reflective layer 1161 may be greater than the length of one side of the first bonding part 1171 by about 4 micrometers to about 10 micrometers.

In addition, the size of the second reflective layer 1162 may be several micrometers larger than the size of the second bonding part 1172. For example, the area of the second reflective layer 1162 may be provided in a size to completely cover the area of the second bonding part 1172. In consideration of a process error, for example, the length of one side of the second reflective layer 1162 may be greater than the length of one side of the second bonding part 1172 by about 4 micrometers to about 10 micrometers.

According to the embodiment, light emitted from the light emitting structure 1110 may be reflected without being incident on the first bonding part 1171 and the second bonding part 1172 by the first reflective layer 1161 and the second reflective layer 1162. Thus, according to the embodiment, a loss of the light generated and emitted from the light emitting structure 1110 and incident to the first bonding part 1171 and the second bonding part 1172 may be minimized.

In addition, according to the light emitting device 1100 of the embodiment, because the third reflective layer 1163 is disposed between the first bonding part 1171 and the second bonding part 1172, the amount of light emitted between the first bonding part 1171 and the second bonding part 1172 may be adjusted.

As described above, the light emitting device 1100 according to the embodiment may be provided as a light emitting device package after being mounted, for example, in a flip chip bonding scheme. Herein, when the package body mounted thereon with the light emitting device 1100 is provided with resin or the like, the package body is discolored or cracked in the lower region of the light emitting device 1100 due to strong short-wavelength light emitted from the light emitting device 1100.

However, according to the light emitting device 1100 of the embodiment, because the amount of light emitted between the region on which the first bonding part 1171 and the second bonding part 1172 are disposed is adjusted, the package body disposed in the lower region of the light emitting device 1100 may be prevented from being discolored or cracked.

According to the embodiment, the light generated from the light emitting structure 1100 may be transmitted and emitted through 20% or more of the area of the upper surface of the light emitting device 1100 on which the first bonding part 1171, the second bonding part 1172 and the third reflective layer 1163.

Thus, according to the embodiment, because the amount of the light emitted in the six-surfaced directions of the light emitting device 1100 is increased, the light extraction efficiency may be improved and the light intensity Po may be increased. In addition, the package body disposed adjacent to the lower surface of the light emitting device 1100 may be prevented from being discolored or cracked.

In addition, according to the light emitting device 1100 of the embodiment, a plurality of contact holes C1, C2, and C3 may be provided in the transparent electrode layer 1130. The second conductive semiconductor layer 1113 may be bonded to the reflective layer 1160 through the plurality of contact holes C1, C2, and C3 provided in the transparent electrode layer 1130. The reflective layer 1160 makes directly contact with the second conductive semiconductor layer 1113, so that the adhesive strength may be improved as compared with the case that the reflective layer 1160 makes contact with the transparent electrode layer 1130.

When the reflective layer 1160 makes direct contact with only the transparent electrode layer 1130, the bonding strength or adhesive strength between the reflective layer 1160 and the transparent electrode layer 1130 may be weakened. For example, when an insulating layer is bonded to a metal layer, the bonding strength or adhesive strength between the materials thereof may be weakened.

For example, when the bonding strength or adhesive strength between the reflective layer 1160 and the transparent electrode layer 1130 is weak, peeling may incur between the two layers. Thus, when the peeling incurs between the reflective layer 1160 and the transparent electrode layer 1130, the characteristics of the light emitting device 1100 may deteriorate and the reliability of the light emitting device 1100 may not be ensured.

However, according to the embodiment, because the reflective layer 1160 can make direct contact with the second conductive semiconductor layer 1113, the bonding strength and adhesive strength may be stably provided between the reflective layer 1160, the transparent electrode layer 1130, and the second conductive semiconductor layer 1113.

Thus, according to the embodiment, because the bonding strength between the reflective layer 1160 and the second conductive semiconductor layer 1113 may be stably provided, the reflective layer 1160 may be prevented from being peeled off from the transparent electrode layer 1130. In addition, because the bonding strength between the reflective layer 1160 and the second conductive semiconductor layer 1113 may be stably provided, the reliability of the light emitting device 1100 may be improved.

Meanwhile, as described above, the transparent electrode layer 1130 may be provided with the contact holes C1, C2, and C3. The light emitted from the active layer 1112 may be incident to and reflected by the reflective layer 1160 through the contact holes C1, C2, and C3 provided in the transparent electrode layer 1130. Accordingly, the loss of the light generated from the active layer 1112 and incident to the transparent electrode layer 1130 is reduced, so that the light extraction efficiency may be improved. Thus, according to the light emitting device 1100 of the embodiment, the light intensity may be improved.

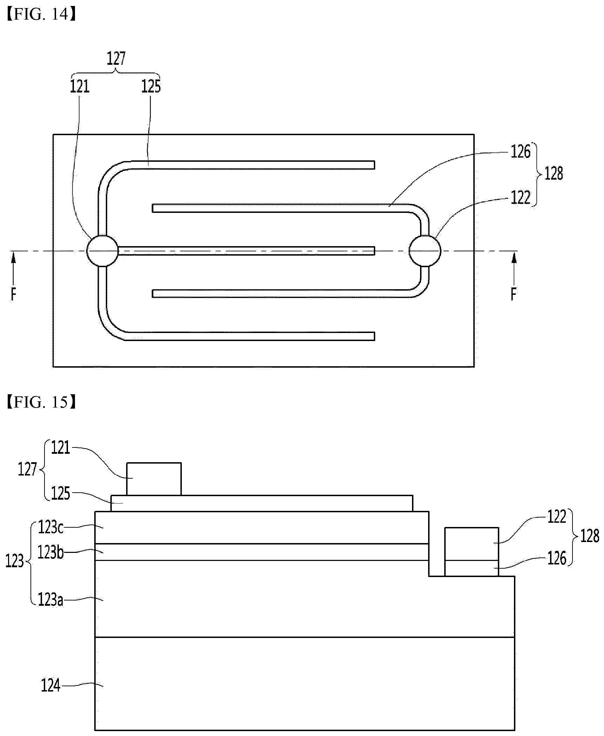

Hereinafter, an example of the flip chip light emitting device applied to the light emitting device package according to the embodiment of the present invention will be described with reference to FIG. 14 and FIG. 15.

FIG. 14 is a plan view describing an electrode arrangement of the light emitting device applied to the light emitting device package according to the embodiment of the present invention, and FIG. 15 is a sectional view taken along the line F-F of the light emitting device shown in FIG. 14.

Meanwhile, for better understanding, FIG. 14 conceptually shows only the relative arrangement of the first electrode 127 and the second electrode 128. The first electrode 127 may include the first bonding part 121 and a first branched electrode 125. The second electrode 128 may include the second bonding part 122 and a second branched electrode 126.

As shown in FIGS. 14 and 15, the light emitting device according to the embodiment may include a light emitting structure 123 disposed on the substrate 124.

The substrate 124 may be selected from the group including a sapphire substrate (Al₂O₃), SiC, GaAs, GaN, ZnO, Si, GaP, InP and Ge. For example, the substrate 124 may be provided as a patterned sapphire substrate (PSS) formed on an upper surface thereof with a concavo-convex pattern.

The light emitting structure 123 may include a first conductive semiconductor layer 123aa, an active layer 123b, and a second conductive semiconductor layer 123c. The active layer 123b may be disposed between the first conductive semiconductor layer 123a and the second conductive semiconductor layer 123c. For example, the active layer 123b may be disposed on the first conductive semiconductor layer 123a, and the second conductive semiconductor layer 123c may be disposed on the active layer 123b.

According to the embodiment, the first conductive semiconductor layer 123a may be provided as an n-type semiconductor layer, and the second conductive semiconductor layer 123c may be provided as a p-type semiconductor layer. According to another embodiment, the first conductive semiconductor layer 123a may be provided as a p-type semiconductor layer, and the second conductive semiconductor layer 123c may be provided as an n-type semiconductor layer.

As shown in FIGS. 14 and 15, the light emitting device according to the embodiment may include the first electrode 127 and the second electrode 128.

The first electrode 127 may include the first bonding part 121 and a first branched electrode 125. The first electrode 127 may be electrically connected to the second conductive semiconductor layer 123c. The first branched electrode 125 may be branched from the first bonding part 121. The first branched electrode 125 may include a plurality of branched electrodes branched from the first bonding part 121.

The second electrode 128 may include the second bonding part 122 and a second branched electrode 126. The second electrode 128 may be electrically connected to the first conductive semiconductor layer 123a. The second branched electrode 126 may be branched from the second bonding part 122. The second branched electrode 126 may include a plurality of branched electrodes branched from the second bonding part 122.

The first branched electrode 125 and the second branched electrode 126 may be alternately arranged to each other in a finger shape. The power supplied through the first bonding part 121 and the second bonding part 122 may spread to the entire light emitting structure 123 by the first branched electrode 125 and the second branched electrode 126.

The first electrode 127 and the second electrode 128 may have a single-layer or multi-layer structure. For example, the first electrode 127 and the second electrode 128 may be ohmic electrodes. For example, the first electrode 127 and the second electrode 128 may include at least one or an alloy formed of at least two of ZnO, IrOx, RuOx, NiO, RuOx/ITO, Ni/IrOx/Au, Ni/IrOx/Au/ITO, Ag, Ni, Cr, Ti, Al, Rh, Pd, Ir, Ru, Mg, Zn, Pt, Au, and Hf.

Meanwhile, the light emitting structure 123 may further include a protective layer. The protective layer may be provided on an upper surface of the light emitting structure 123. In addition, the protective layer may be provided on a side surface of the light emitting structure 123. The protective layer may be provided to exposure the first bonding part 121 and the second bonding part 122. In addition, the protective layer may be selectively provided on a periphery and a lower surface of the substrate 124.

For example, the protective layer may be provided as an insulating material. For example, the protective layer may be formed of at least one material selected from the group including SiₓO_{y}, SiOₓN_{y}, SiₓN_{y}, and AlₓO_{y}.

In the light emitting device according to the embodiment, light generated in the active layer 123b may be emitted in six-surfaced directions of the light emitting device. The light generated in the active layer 123b may be emitted in six-surfaced directions through an upper surface, a lower surface, and four side surfaces of the light emitting device.

For reference, the vertical direction of the light emitting device described with reference to FIGS. 1 to 11 and the vertical direction of the light emitting device shown in FIGS. 14 and 15 are shown opposite to each other.

According to the embodiment, the sum of the areas of the first and second bonding parts 121 and 122 may be 10% or less based on the area of the upper surface of the substrate 124. According to the light emitting device package of the embodiment, the sum of the areas of the first and second bonding parts 121 and 122 may be 10% or less based on the area of the substrate 124 to increase the light extraction efficiency by ensuring the light emitting area from the light emitting device.

In addition, according to the embodiment, the sum of the areas of the first and second bonding parts 121 and 122 may be 0.7% or more based on the area of the upper surface of the substrate 124. According to the light emitting device package of the embodiment, the sum of the areas of the first and second bonding parts 121 and 122 may be 0.7% or more based on the area of the upper surface of the substrate 124.

For example, the width of the first bonding part 121 in a long axis direction of the light emitting device may be tens of micrometers. The width of the first bonding part 121 may be in the range of 70 micrometers to 90 micrometers. In addition, the area of the first bonding part 121 may be thousands of square micrometers.

In addition, the width of the second bonding part 122 in the long axis direction of the light emitting device may be tens of micrometers. The width of the second bonding part 122 may be in the range of 70 micrometers to 90 micrometers. In addition, the area of the second bonding part 122 may be thousands of square micrometers.

Accordingly, when the area of the first and second bonding parts 121 and 122 is reduced, the amount of light transmitted to the lower surface of the light emitting device 120 may be increased.

Meanwhile, the light emitting device package according to the embodiment described with reference to FIGS. 1 to 11 has been described based on a case where the first and second bonding parts 121 and 122 make direct contact with the first and second conductive layers 321 and 322, respectively.

However, according to the light emitting device package of another embodiment, an additional conductive component may be further provided between the first and second bonding parts 121 and 122 and the first and second conductive layers 321 and 322.

### [Industrial Applicability]

The light emitting device package according to the embodiment may be applied to the light source apparatus.

Further, the light source apparatus may include a display apparatus, a lighting apparatus, a head lamp, and the like based on the industrial field.

As an example of the light source apparatus, the display apparatus includes a bottom cover, a reflective plate disposed on the bottom cover, a light emitting module emitting light and including a light emitting device, a light guide plate disposed on a front of the reflective plate and guiding light emitted from the light emitting module, an optical sheet including prism sheets disposed in front of the light guide plate, a display panel disposed in front of the optical sheet, an image signal output circuit connected to the display panel and supplying an image signal to the display panel, and a color filter disposed in front of the display panel. Herein, the bottom cover, the reflective plate, the light emitting module, the light guide plate, and the optical sheet may form a backlight unit. In addition, the display apparatus may have a structure in which light emitting devices each emitting red, green, and blue light are disposed without including the color filter.

As another example of the light source apparatus, the head lamp may include a light emitting module including a light emitting device package disposed on a substrate, a reflector for reflecting light emitted from the light emitting module in a predetermined direction, for example, in a forward direction, a lens for forwardly refracting the light, and a shade for blocking or reflecting a portion of the light reflected by the reflector and directed to the lens to form a light distribution pattern desired by a designer.

The lighting apparatus as another light source apparatus may include a cover, a light source module, a heat sink, a power supply, an inner case, and a socket. In addition, the light source apparatus according to an embodiment may further include at least one of a member and a holder. The light source module may include a light emitting device package according to the embodiment.

The features, structures, effects and the like described in the above embodiments are included in at least one embodiment and are not limited to one embodiment only. Further, with respect to the features, structures, effects, and the like described in the embodiments, other embodiments may be carried out with combinations or modifications by those having ordinary skill in the art. Accordingly, the contents relevant to the combinations and modifications should be construed as being included in the scope of the embodiments.

### [Description of Reference numerals]

110: Package body
113: First package body
117: Second package body
120: Light emitting device
121: First bonding part
122: Second bonding part
123: Light emitting structure
124: Substrate
130: First resin
140: Second resin
160: Adhesive layer
310: Circuit board
311: First pad
312: Second pad
313: Support substrate
321: First conductive layer
322: Second conductive layer
R: Recess
TH1: First opening part
TH2: Second opening part

## Claims

1. A light emitting device package comprising:
a first package body (113) having first and second through holes (TH1, TH2);
a light emitting device (120) including first and second bonding parts (121, 122);
a second package body (117) having a first opening with the light emitting device (120) being in the first opening;
an adhesive layer (160) between the first and second package bodies (113, 117) for coupling the first package body (113) and the second package body (117);
a first resin (130) disposed between the first package body (113) and the light emitting device (120); and
first and second conductive layers (321, 322) disposed in the first through hole (TH1) and the second through hole (TH2), respectively,
wherein the first bonding part (121) of the light emitting device (120) overlaps with the first through hole (TH1) and the second bonding part (122) of the light emitting device (120) overlaps with the second through hole (TH2),
wherein the first bonding part (121) and the second bonding part (122) are spaced apart from each other,
wherein the first and second conductive layers (321, 322) in the first and second through holes (TH1, TH2) respectively contacts the first and second bonding parts (121, 122), and a first side surface of the first bonding part (121) and a second side surface of the second bonding part (122) facing the first side surface contact the first resin (130), and
**characterized in that** the adhesive layer (160) is disposed at the periphery of the light emitting device (120) to form a cavity, and
wherein the light emitting device package further comprises a first conductor (221) and a second conductor (222),
wherein the first conductor (221) is provided in the first through hole (TH1) and disposed between the first bonding part (121) and the first conductive layer (321),
wherein the first conductor (221) is electrically connected to the first bonding part (121) and the first conductive layer (321),
wherein the second conductor (222) is provided in the second through hole (TH2) and disposed between the second bonding part (122) and the second conductive layer (322),
wherein the second conductor (222) is electrically connected to the second bonding part (122) and the second conductive layer (322),
wherein the first conductive layer (321) is disposed on a lower surface and a side surface of the first conductor (221), and
wherein the second conductive layer (322) is disposed on a lower surface and a side surface of the second conductor (222).

2. The light emitting device package of claim 1, wherein the light emitting device (120) further includes:
a light emitting structure (123) including a first conductive layer, an active layer on the first conductive layer, and a second conductive layer on the active layer, and
wherein the first and second bonding parts (121, 122) are spaced apart from each other on the light emitting structure (123).

3. The light emitting device package of claim 1, wherein the first package body (113) further includes a recess (R) between the first and second through holes (TH1, TH2).

4. The light emitting device package of claim 3, wherein the first resin (130) is disposed in the recess (R).

5. The light emitting device package of claim 1, wherein the first and second conductive layers (321, 322) include Sn.

6. The light emitting device package of claim 1, wherein the first and second through holes (TH1, TH2) have inclined inner surfaces.

7. The light emitting device package of claim 6, wherein the inclined inner surfaces of the first and second through holes (TH1, TH2) incline outwards from the upper surface of the first package body (113) to the lower surface of the first package body (113).

8. The light emitting device package of claim 1, wherein a material of the first package body (113) is different than a material of the second package body (117).

9. The light emitting device package of claim 1, wherein the second package body (117) includes phosphor.

10. The light emitting device package of claim 1, wherein the first package body (113) includes phosphor.

11. The light emitting device package of claim 1, wherein widths of the first and second through holes (TH1, TH2) at a lower surface of the first package body (113) is greater than widths of the first and second through holes (TH1, TH2) at an upper surface of the first package body (113).

12. The light emitting device package of claim 1, wherein the light emitting device (120) is disposed on the upper surface of the first package body (113) with the first and second through holes (TH1, TH2) being disposed below the light emitting device (120).

## Patentansprüche

1. Lichtemittierungsvorrichtungsbaugruppe, umfassend:
einen ersten Baugruppenkörper (113) mit ersten und zweiten Durchgangslöchern (TH1, TH2);
eine Lichtemittierungsvorrichtung (120) umfassend erste und zweite Bonding-Teile (121, 122);
einen zweiten Baugruppenkörper (117) mit einer ersten Öffnung, wobei die Lichtemittierungsvorrichtung (120) in der ersten Öffnung ist;
eine Haftschicht (160) zwischen den ersten und zweiten Baugruppenkörpern (113, 117) zum Verbinden des ersten Baugruppenkörpers (113) und des zweiten Baugruppenkörpers (117);
ein erstes Harz (130), das zwischen dem ersten Baugruppenkörper (113) und der Lichtemittierungsvorrichtung (120) angeordnet ist; und
erste und zweite leitende Schichten (321, 322), die jeweils in dem ersten Durchgangsloch (TH1) und dem zweiten Durchgangsloch (TH2) angeordnet sind,
wobei das erste Bonding-Teil (121) der Lichtemittierungsvorrichtung (120) mit dem ersten Durchgangsloch (TH1) überlappt und das zweite Bonding-Teil (122) der Lichtemittierungsvorrichtung (120) mit dem zweiten Durchgangsloch (TH2) überlappt,
wobei das erste Bonding-Teil (121) und das zweite Bonding-Teil (122) voneinander beabstandet sind,
wobei die ersten und zweiten leitenden Schichten (321, 322) in den ersten und zweiten Durchgangslöchern (TH1, TH2) jeweils die ersten und zweiten Bonding-Teile (121, 122) kontaktieren, und eine erste seitliche Oberfläche des ersten Bonding-Teils (121) und eine der ersten seitlichen Oberfläche zugewandte zweite seitliche Oberfläche des zweiten Bonding-Teils (122) das erste Harz (130) kontaktieren, und
**dadurch gekennzeichnet, dass** die Haftschicht (160) an der Peripherie der Lichtemittierungsvorrichtung (120) angeordnet ist, um einen Hohlraum zu bilden, und
wobei die Lichtemittierungsvorrichtungsbaugruppe ferner einen ersten Leiter (221) und einen zweiten Leiter (222) umfasst,
wobei der erste Leiter (221) in dem ersten Durchgangsloch (TH1) vorgesehen ist und zwischen dem ersten Bonding-Teil (121) und der ersten leitenden Schicht (321) angeordnet ist,
wobei der erste Leiter (221) mit dem ersten Bonding-Teil (121) und der ersten leitenden Schicht (321) elektrisch verbunden ist,
wobei der zweite Leiter (222) in dem zweiten Durchgangsloch (TH2) vorgesehen ist und zwischen dem zweiten Bonding-Teil (122) und der zweiten leitenden Schicht (322) angeordnet ist,
wobei der zweite Leiter (222) mit dem zweiten Bonding-Teil (122) und der zweiten leitenden Schicht (322) elektrisch verbunden ist,
wobei die erste leitende Schicht (321) auf einer unteren Oberfläche und einer seitlichen Oberfläche des ersten Leiters (221) angeordnet ist, und
wobei die zweite leitende Schicht (322) auf einer unteren Oberfläche und einer seitlichen Oberfläche des zweiten Leiters (222) angeordnet ist.

2. Lichtemittierungsvorrichtungsbaugruppe nach Anspruch 1, wobei die Lichtemittierungsvorrichtung (120) ferner umfasst:
eine lichtemittierende Struktur (123) umfassend eine erste leitende Schicht, eine aktive Schicht auf der ersten leitenden Schicht und eine zweite leitende Schicht auf der aktiven Schicht, und
wobei die ersten und zweiten Bonding-Teile (121, 122) auf der lichtemittierenden Struktur (123) voneinander beabstandet sind.

3. Lichtemittierungsvorrichtungsbaugruppe nach Anspruch 1, wobei der erste Baugruppenkörper (113) ferner eine Aussparung (R) zwischen den ersten und zweiten Durchgangslöchern (TH1, TH2) umfasst.

4. Lichtemittierungsvorrichtungsbaugruppe nach Anspruch 3, wobei das erste Harz (130) in der Aussparung (R) angeordnet ist.

5. Lichtemittierungsvorrichtungsbaugruppe nach Anspruch 1, wobei die ersten und zweiten leitenden Schichten (321, 322) Sn enthalten.

6. Lichtemittierungsvorrichtungsbaugruppe nach Anspruch 1, wobei die ersten und zweiten Durchgangslöcher (TH1, TH2) geneigte innere Oberflächen aufweisen.

7. Lichtemittierungsvorrichtungsbaugruppe nach Anspruch 6, wobei die geneigten inneren Oberflächen der ersten und zweiten Durchgangslöcher (TH1, TH2) von der oberen Oberfläche des ersten Baugruppenkörpers (113) zu der unteren Oberfläche des ersten Baugruppenkörpers (113) nach außen neigen.

8. Lichtemittierungsvorrichtungsbaugruppe nach Anspruch 1, wobei ein Material des ersten Baugruppenkörpers (113) anders ist als ein Material des zweiten Baugruppenkörpers (117).

9. Lichtemittierungsvorrichtungsbaugruppe nach Anspruch 1, wobei der zweite Baugruppenkörper (117) Phosphor enthält.

10. Lichtemittierungsvorrichtungsbaugruppe nach Anspruch 1, wobei der erste Baugruppenkörper (113) Phosphor enthält.

11. Lichtemittierungsvorrichtungsbaugruppe nach Anspruch 1, wobei Breiten der ersten und zweiten Durchgangslöcher (TH1, TH2) an einer unteren Oberfläche des ersten Baugruppenkörpers (113) größer sind als Breiten der ersten und zweiten Durchgangslöcher (TH1, TH2) an einer oberen Oberfläche des ersten Baugruppenkörpers (113).

12. Lichtemittierungsvorrichtungsbaugruppe nach Anspruch 1, wobei die Lichtemittierungsvorrichtung (120) auf der oberen Oberfläche des ersten Baugruppenkörpers (113) angeordnet ist, wobei die ersten und zweiten Durchgangslöcher (TH1, TH2) unterhalb der Lichtemittierungsvorrichtung (120) angeordnet sind.

## Revendications

1. Un boîtier de dispositif électroluminescent comprenant :
un premier corps de boîtier (113) ayant des premier et deuxième trous traversants (TH1, TH2) ;
un dispositif électroluminescent (120) comprenant des première et deuxième parties de liaison (121, 122) ;
un deuxième corps de boîtier (117) ayant une première ouverture, le dispositif électroluminescent (120) étant dans la première ouverture ;
une couche adhésive (160) entre les premier et deuxième corps de boîtier (113, 117) pour relier le premier corps de boîtier (113) et le deuxième corps de boîtier (117) ;
une première résine (130) disposée entre le premier corps de boîtier (113) et le dispositif électroluminescent (120) ; et
des première et deuxième couches conductrices (321, 322) disposées respectivement dans le premier trou traversant (TH1) et le deuxième trou traversant (TH2),
la première partie de liaison (121) du dispositif électroluminescent (120) étant en chevauchement avec le premier trou traversant (TH1) et la deuxième partie de liaison (122) du dispositif électroluminescent (120) étant en chevauchement avec le deuxième trou traversant (TH2),
la première partie de liaison (121) et la deuxième partie de liaison (122) étant espacées l'une de l'autre,
les première et deuxième couches conductrices (321, 322) dans les premier et deuxième trous traversants (TH1, TH2) étant respectivement en contact avec les première et deuxième parties de liaison (121, 122), et une première surface latérale de la première partie de liaison (121) et une deuxième surface latérale de la deuxième partie de liaison (122) étant tournées vers la première surface latérale en contact avec la première résine (130), et
**caractérisé en ce que** la couche adhésive (160) est disposée à la périphérie du dispositif électroluminescent (120) pour former une cavité, et
le boîtier de dispositif électroluminescent comprenant en outre un premier conducteur (221) et un deuxième conducteur (222),
le premier conducteur (221) étant prévu dans le premier trou traversant (TH1) et disposé entre la première partie de liaison (121) et la première couche conductrice (321),
le premier conducteur (221) étant connecté électriquement à la première partie de liaison (121) et à la première couche conductrice (321),
le deuxième conducteur (222) étant prévu dans le deuxième trou traversant (TH2) et disposé entre la deuxième partie de liaison (122) et la deuxième couche conductrice (322),
le deuxième conducteur (222) étant connecté électriquement à la deuxième partie de liaison (122) et à la deuxième couche conductrice (322),
la première couche conductrice (321) étant disposée sur une surface inférieure et une surface latérale du premier conducteur (221), et
la deuxième couche conductrice (322) étant disposée sur une surface inférieure et une surface latérale du deuxième conducteur (222).

2. Le boîtier de dispositif électroluminescent selon la revendication 1, dans lequel le dispositif électroluminescent (120) comprend en outre :
une structure (123) émettrice de lumière comprenant une première couche conductrice, une couche active sur la première couche conductrice et une deuxième couche conductrice sur la couche active, et
les première et deuxième parties de liaison (121, 122) étant espacées l'une de l'autre sur la structure (123) émettrice de lumière.

3. Le boîtier de dispositif électroluminescent selon la revendication 1, dans lequel le premier corps de boîtier (113) comprend en outre un évidement (R) entre les premier et deuxième trous traversants (TH1, TH2).

4. Le boîtier de dispositif électroluminescent selon la revendication 3, dans lequel la première résine (130) est disposée dans l'évidement (R).

5. Le boîtier de dispositif électroluminescent selon la revendication 1, dans lequel les première et deuxième couches conductrices (321, 322) comprennent du Sn.

6. Le boîtier de dispositif électroluminescent selon la revendication 1, dans lequel les premier et deuxième trous traversants (TH1, TH2) ont des surfaces internes inclinées.

7. Le boîtier de dispositif électroluminescent selon la revendication 6, dans lequel les surfaces intérieures inclinées des premier et deuxième trous traversants (TH1, TH2) s'inclinent vers l'extérieur depuis la surface supérieure du premier corps de boîtier (113) vers la surface inférieure du premier corps de boîtier (113).

8. Le boîtier de dispositif électroluminescent selon la revendication 1, dans lequel un matériau du premier corps de boîtier (113) est différent d'un matériau du deuxième corps de boîtier (117).

9. Le boîtier de dispositif électroluminescent selon la revendication 1, dans lequel le deuxième corps de boîtier (117) comprend du phosphore.

10. Le boîtier de dispositif électroluminescent selon la revendication 1, dans lequel le premier corps de boîtier (113) comprend du phosphore.

11. Le boîtier de dispositif électroluminescent selon la revendication 1, dans lequel les largeurs des premier et deuxième trous traversants (TH1, TH2) au niveau d'une surface inférieure du premier corps de boîtier (113) sont supérieures aux largeurs des premier et deuxième trous traversants (TH1, TH2) au niveau d'une surface supérieure du premier corps de boîtier (113).

12. Le boîtier de dispositif électroluminescent selon la revendication 1, dans lequel le dispositif électroluminescent (120) est disposé sur la surface supérieure du premier corps de boîtier (113), les premier et deuxième trous traversants (TH1, TH2) étant disposés sous le dispositif électroluminescent (120).
